# EUROPEAN PATENT APPLICATION

(11) **EP 4 478 128 A1**
(43) Date of publication of application: **18.12.2024**
(21) Application number: 24178599.7
(22) Date of filing: 28.05.2024
(51) Int. Cl.: G03F 7/09, G03F 7/11, H01L 21/02, H01L 21/027

(54) **COMPOSITION FOR FORMING METAL-CONTAINING FILM AND PATTERNING PROCESS**

(30) Priority: 07.06.2023 JP 2023093597
(71) Applicant: SHIN-ETSU CHEMICAL CO., LTD., Tokyo 1000005 (JP)
(72) Inventor: KOBAYASHI, Naoki, Niigata (JP); ISHIWATA, Kenta, Niigata (JP); NAGAMACHI, Nobuhiro, Niigata, Niigata (JP); IWAMORI, Shohei, Niigata (JP); KORI, Daisuke, Niigata (JP)
(74) Representative: Sonnenhauser, Thomas Martin

(57) **Abstract**

The present invention is a composition for forming a metal-containing film, containing: (A) a metal compound; (B) a surface modifier; and (C) a solvent, where the metal compound contains at least one metal atom selected from the group consisting of Ti, Zr, and Hf, and the surface modifier (B) is a polymer containing one or both of a repeating unit represented by the following general formula (1) and a repeating unit represented by the following general formula (2), and the polymer does not contain a repeating unit containing a hydroxy group, where R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms. This can provide a metal-containing film in which an excellent pattern profile can be achieved and which can suppress fine-pattern collapse.

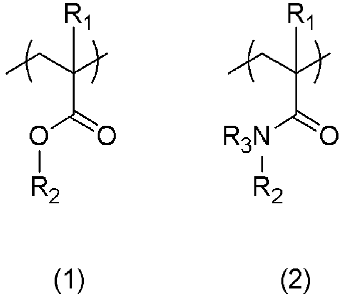

## Description

### TECHNICAL FIELD

The present invention relates to: a composition for forming a metal-containing film, usable for fine patterning according to a multilayer resist method in a semiconductor device manufacturing process; and a patterning process using the composition.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

As a silicon-containing resist middle layer film used in a three-layer resist method like the method described above, used are: a silicon-containing inorganic film obtained by CVD, for example, an SiO₂ film (e.g. Patent Document 2 etc.) or an SiON film (e.g. Patent Document 3 etc.); a film obtained by spin-coating, such as an SOG (spin-on-glass) film (e.g. Patent Document 4 etc. and Non Patent Document 1) or a crosslinkable silsesquioxane film (e.g. Patent Document 5 etc.); etc. A polysilane film (e.g. Patent Document 6 etc.) should also be usable. Among these films, an SiO₂ film and an SiON film have high performance as dry etching masks when the organic film underneath is dry-etched, but require special equipment for film formation. On the other hand, an SOG film, a crosslinkable silsesquioxane film, and a polysilane film can be formed just by spin-coating and heating, and are thought to have high process efficiency.

There are some problems with such silicon-containing films, conventionally used in multilayer resist methods. For example, when a resist pattern is to be formed by photolithography, it is well known that exposure light is reflected off a substrate and interferes with incident light, causing a problem in so-called standing waves, and therefore, in order to obtain a fine pattern having no edge roughness of the resist film under the most advanced ArF immersion and high-NA exposure conditions, an antireflective function is essential in a middle layer film. Furthermore, in the most advanced semiconductor processes described above, the thinning of photoresists has progressed considerably, and therefore, middle layer films are also required to be thinned. In next-generation exposure processes, it is required to provide an antireflective effect with a film thickness of 30 nm or less. In addition, dry etching speed when using oxygen gas plasma, which is commonly used when processing a resist underlayer film, is preferably low, so as to increase the etching selectivity between a middle layer film and an underlayer film, and in the course of thinning, middle layer films are required to have improved dry etching resistance.

As resist middle layer films that satisfy such requirements for an antireflective effect and dry etching property, metal-containing films (metal hard mask films) containing Ti or Zr are attracting attention, in place of conventional silicon-containing films. TiO₂ and ZrO₂ are known as high refractive index materials, and it is possible to enhance an antireflective effect under high-NA exposure conditions by these materials being contained in a film. In addition, excellent dry etching resistance to oxygen gas can be expected by metal-oxygen bonds being included.

Moreover, metal-containing films have excellent dry etching resistance not only to oxygen gas but also to fluorine gas, and therefore, excellent dry etching resistance can also be expected in two-layer resist methods where a metal-containing film is formed as a resist underlayer film on a substrate to be processed, and a resist upper layer film is formed thereon.

On the other hand, when such a metal-containing film is used directly under a resist upper layer film, the improvement of adhesiveness to a resist pattern is a problem. A cured metal-containing film has much higher surface energy (or a smaller contact angle with water) than a photoresist applied subsequently. This mismatch in surface energy causes adhesion failure between the metal-containing film and the subsequently applied photoresist, and brings about pattern collapse.

Surface modification of the metal-containing film is necessary for suppressing photoresist pattern collapse on the metal-containing film, and for example, Patent Document 7 reports a metal hard mask containing a surface-modified organic polymer. It is reported that, by using the difference between the free energies of the organic polymer and the metal compound and allowing the organic polymer to be unevenly distributed on a surface layer, adhesiveness to a resist pattern can be improved. For suppressing pattern collapse, used are organic polymers including surface-treated moieties selected from hydroxyl, protected hydroxyl, protected carboxyl, and mixtures thereof. However, in the current situation, where finer pattern formation is required, it cannot be said that these materials have sufficient pattern collapse suppression performance.

Nowadays, it is considered that interaction between a resist upper layer film and an underlayer film directly under the resist upper layer film in a fine pattern at the interface also has an influence on the sensitivity of the resists, pattern profile (rectangularity and residue in space portions), etc., and improved performance is required in the underlayer film directly under the resist upper layer film from these viewpoints as well (Non Patent Document 2).

### CITATION LIST

### PATENT LITERATURE

Patent Document 1: JP2004-205685A
Patent Document 2: JPH7-183194A
Patent Document 3: JPH7-181688A
Patent Document 4: JPH5-291208A
Patent Document 5: JP2005-520354A
Patent Document 6: JPH11-60735A
Patent Document 7: JP6463600B2

### NON PATENT LITERATURE

Non Patent Document 1: J. Appl. Polym. Sci., Vol. 88, 636-640 (2003)
Non Patent Document 2: Proc. SPIE Vol. 7273, 72731J (2009)

### SUMMARY OF INVENTION

### TECHNICAL PROBLEM

The present invention has been made in view of the above-described circumstances. An object of the present invention is to provide: a composition for forming a metal-containing film that gives a metal-containing film that makes it possible to obtain an excellent pattern profile, has high adhesiveness to a resist upper layer film, and can suppress fine-pattern collapse in a fine patterning process of a semiconductor device manufacturing process; and a patterning process using the composition.

### SOLUTION TO PROBLEM

To achieve the object, the present invention provides a composition for forming a metal-containing film, comprising:
(A) a metal compound;
(B) a surface modifier; and
(C) a solvent,

wherein the metal compound contains at least one kind of metal atom selected from the group consisting of Ti, Zr, and Hf, and
the surface modifier (B) is a polymer containing one or both of a repeating unit represented by the following general formula (1) and a repeating unit represented by the following general formula (2), and the polymer does not contain a repeating unit containing a hydroxy group, 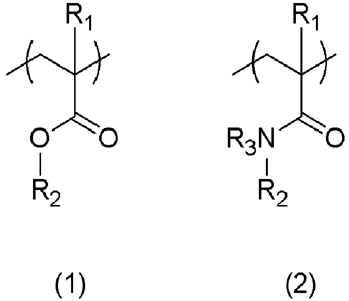
wherein R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.

Such a composition for forming a metal-containing film makes it possible to form a metal-containing film that has high adhesiveness to a resist upper layer film, has an effect of preventing a fine pattern from collapsing, and gives an excellent pattern profile. In addition, the obtained metal-containing film exhibits a high refractive index, and therefore, can exert a high antireflective effect under ArF immersion and high-NA exposure conditions.

Furthermore, the heterocyclic structure preferably contains an oxygen atom.

When the composition for forming a metal-containing film has such a structure, higher adhesiveness to a resist upper layer film can be achieved, and the composition is further effective for preventing fine-pattern collapse.

Furthermore, the R₂ in the general formulae (1) and (2) preferably represents a monovalent organic group containing a group selected from the following formulae (R₂-1) to (R₂-3), 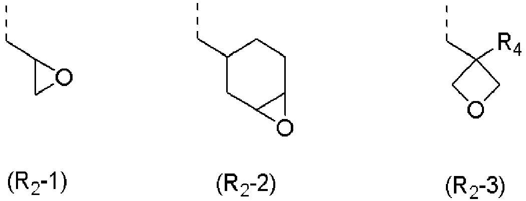 wherein R₄ represents a hydrogen atom or an alkyl group having 1 to 10 carbon atoms; and a broken line represents an attachment point.

When the composition for forming a metal-containing film contains a surface modifier (B) having such a structure, higher adhesiveness to a resist upper layer film can be achieved, and the composition is further effective for preventing fine-pattern collapse.

Furthermore, the surface modifier (B) is preferably a polymer further containing any repeating unit represented by the following formula (3a) or formula (3b), 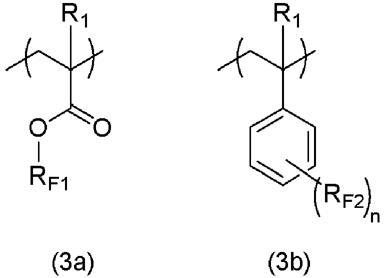 wherein R_{F1} represents a monovalent organic group having 1 to 20 carbon atoms and containing at least one F atom; R_{F2} represents an F atom or a monovalent organic group having 1 to 10 carbon atoms and containing one or more F atoms; R₁ represents a hydrogen atom or a methyl group; and "n" represents 1 to 5.

It is preferable to use such a surface modifier, since the surface modifier can be more easily distributed unevenly on a surface layer of the metal-containing film.

Furthermore, the polymer, which is the surface modifier (B), preferably has a weight-average molecular weight of 6,000 to 50,000.

Furthermore, the polymer, which is the surface modifier (B), preferably has a dispersity of 3.0 or less, the dispersity being expressed as "weight-average molecular weight"/"number-average molecular weight".

When the weight-average molecular weight and/or the dispersity of the polymer contained in the composition for forming a metal-containing film are/is within such ranges, excellent film-formability can be obtained, and in addition, the generation of sublimation products during heat-curing can be suppressed, so that the contamination of apparatuses can be prevented.

Furthermore, the surface modifier (B) contained in the composition for forming a metal-containing film is preferably contained in a ratio of 1 part by mass or more and 50 parts by mass or less to 100 parts by mass of the metal compound.

When the surface modifier is contained in such a ratio, higher adhesiveness to a resist upper layer film can be achieved without degrading the dry etching resistance and refractive index of the composition for forming a metal-containing film, and the composition is further effective for preventing fine-pattern collapse.

Furthermore, the composition preferably further comprises at least one of:
(D) a thermal acid generator;
(E) a photo-acid generator;
(F) a crosslinking agent; and
(G) a surfactant.

By the presence/absence and choice of these additives, it is possible to make fine adjustments to performance in accordance with customer requirements regarding film-formability, reduction of sublimation products, and furthermore, various properties of resist patterning. Therefore, such additives are preferable for practical use.

Furthermore, the solvent (C) preferably contains a high-boiling-point solvent (C-1), and
the high-boiling-point solvent (C-1) is one or more kinds of organic solvent having a boiling point of 180°C or higher.

When such a high-boiling-point solvent is contained, sufficient thermal flowability can be achieved during film formation, and therefore, when a metal-containing film is formed, it is possible to achieve both high etching selectivity of the metal compound (A) and high pattern adhesiveness of the surface modifier (B) without forming a sea-island structure.

Furthermore, the metal compound (A) is preferably derived from a metal compound represented by the following general formula (4),

LₐMX_{b} (4)

wherein M represents any of Ti, Zr, and Hf; L represents a monodentate ligand having 1 to 30 carbon atoms or a polydentate ligand having 1 to 30 carbon atoms; X represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

When such a metal compound is contained, it is possible to form a metal-containing film having better dry etching resistance to oxygen gas.

In this case, the metal compound (A) is more preferably a reaction product of a reaction between: a compound derived from the metal compound represented by the general formula (4); and an organic compound having 1 to 30 carbon atoms and containing at least one crosslinking group represented by any of the following general formulae (a-1) to (a-4), (b-1) to (b-4), and (c-1) to (c-3), 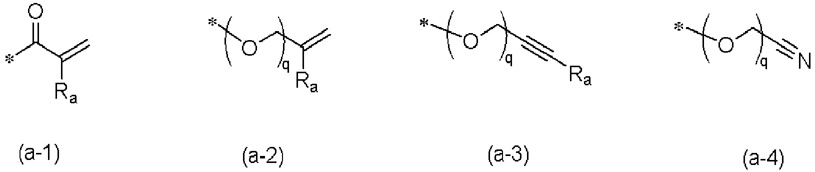 wherein Rₐ represents a hydrogen atom or a monovalent organic group having 1 to 10 carbon atoms, "q" represents 0 or 1, and "*" represents an attachment point, 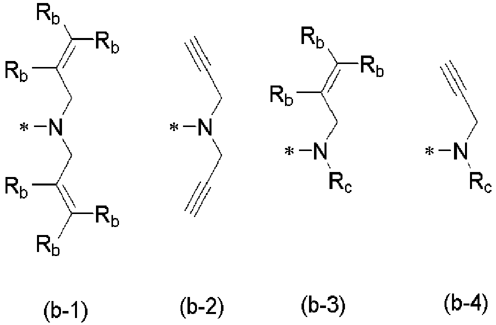 wherein R_{b}s each represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 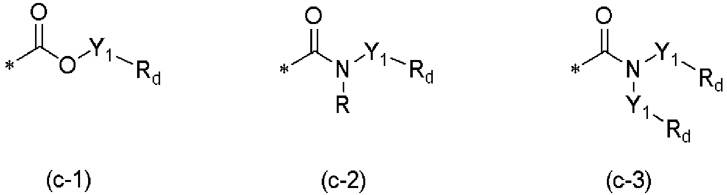 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R_{d} represents an organic group whose protecting group is to be removed by an action of an acid, heat, or both to generate one or more hydroxy groups or carboxy groups, R_{d} being represented by one of the following general formulae (c-4), and "*" represents an attachment point, 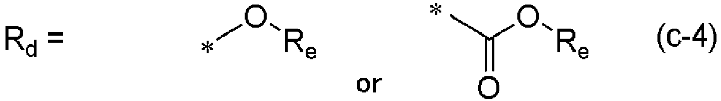 wherein Rₑ represents an organic group whose protecting group is to be removed by an action of an acid, heat, or both, and "*" represents an attachment point to Y₁.

When the metal compound (A) contains such an organic group, sufficient thermal flowability can be achieved during film formation, and therefore, when a metal-containing film is formed, it is possible to achieve both higher etching selectivity of the metal compound (A) and higher pattern adhesiveness of the surface modifier (B) without forming a sea-island structure.

The present invention also provides a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The present invention also provides a patterning process for forming a pattern in a substrate to be processed, comprising the steps of:
(II-1) forming a resist underlayer film on a substrate to be processed;
(II-2) applying the inventive composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.

In this manner, the inventive composition for forming a metal-containing film can be used suitably in various patterning processes such as two-layer resist processes and three-layer resist processes. These patterning processes make it possible to suppress pattern collapse effectively by the use of a metal-containing film provided by the present invention and is suitable for photolithography of a resist upper layer film, and also make it possible to transfer a resist upper layer film pattern to a substrate to be processed with high precision.

### ADVANTAGEOUS EFFECTS OF INVENTION

As described above, the present invention provides a composition for forming a metal-containing film that has high adhesiveness to a resist upper layer film and has a fine-pattern collapse-suppression effect. Furthermore, the composition for forming a metal-containing film not only has high adhesiveness and a fine-pattern collapse-suppression effect, but also gives a substrate to be processed a high-rectangularity resist upper layer film pattern profile, and therefore, the composition is extremely useful in multilayer resist processes. Moreover, the inventive composition for forming a metal-containing film is excellent in resistance to dry etching using each one of oxygen gas and fluorine gas, and therefore, makes it possible to form highly accurately a fine pattern in a substrate to be processed in various patterning processes such as two-layer resist processes and three-layer resist processes.

### BRIEF DESCRIPTION OF DRAWINGS

FIG. 1 is an explanatory diagram of an example (three-layer resist process) of the inventive patterning process.
FIG. 2 is an explanatory diagram of an example (two-layer resist process) of the inventive patterning process.
FIG. 3 is an explanatory diagram of reflectance calculation in a patterning process.

### DESCRIPTION OF EMBODIMENTS

As stated above, there have been demands for the development of: a composition for forming a metal-containing film that gives a metal-containing film in which it is possible to achieve an excellent pattern profile and which has high adhesiveness to a resist upper layer film so that fine-pattern collapse can be suppressed in a fine patterning process of a semiconductor device manufacturing process; and a patterning process using the composition.

The present inventors have studied the above-described object earnestly and found out that the object can be achieved by a composition for forming a metal-containing film, containing a polymer having a specific structure, and a patterning process using the composition for forming a metal-containing film, and completed the present invention.

That is, the present invention is a composition for forming a metal-containing film, comprising:
(A) a metal compound;
(B) a surface modifier; and
(C) a solvent,

wherein the metal compound contains at least one kind of metal atom selected from the group consisting of Ti, Zr, and Hf, and
the surface modifier (B) is a polymer containing one or both of a repeating unit represented by the following general formula (1) and a repeating unit represented by the following general formula (2), and the polymer does not contain a repeating unit containing a hydroxy group, 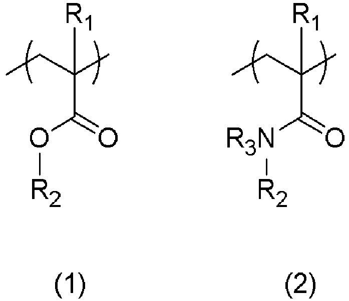
wherein R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.

In addition, the present invention is a patterning process for forming a pattern in a substrate to be processed, comprising the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

In addition, the present invention is a patterning process for forming a pattern in a substrate to be processed, comprising the steps of:
(II-1) forming a resist underlayer film on a substrate to be processed;
(II-2) applying the inventive composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.

Hereinafter, the present invention will be described in detail, but the present invention is not limited thereto.

### <Composition for Forming Metal-Containing Film>

The present invention is a composition for forming a metal-containing film, containing:
(A) a metal compound;
(B) a surface modifier; and
(C) a solvent,

where the metal compound contains at least one kind of metal atom selected from the group consisting of Ti, Zr, and Hf, and
the surface modifier (B) is a polymer containing one or both of a repeating unit represented by the following general formula (1) and a repeating unit represented by the following general formula (2), and the polymer does not contain a repeating unit containing a hydroxy group.

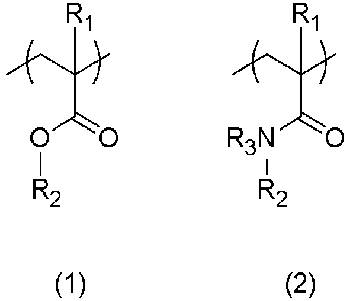

In the formulae, R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.

Note that in the inventive composition for forming a metal-containing film, as each of the metal compound (A), the surface modifier (B), and the solvent (C), one component may be used, or two or more components may be used in combination. Furthermore, the composition for forming a metal-containing film may contain components other than the components (A), (B), and (C). In the following, each component will be described.

### <(A) Metal Compound>

The metal compound (A) contained in the inventive composition for forming a metal-containing film contains at least one kind of metal atom selected from the group consisting of Ti, Zr, and Hf.

When such a metal is contained, it is possible to increase the refractive index of a heat-treated metal-containing film, and it is also possible to form a metal-containing film having excellent resistance to dry etching using an oxygen gas and a fluorine gas.

The proportion of the metal element atom contained in the metal compound (A) preferably has a lower limit of 10 mass%, more preferably 20 mass%, and further preferably 30 mass%. The upper limit of the contained proportion is preferably 50 mass%. The proportion of the metal element atom contained can be determined by measurement using a differential thermal analyzer (TG/DTA).

When the proportion of the metal element is as described, it is possible to enhance further the refractive index of the composition for forming a metal-containing film and dry etching resistance to oxygen gas and fluorine gas.

The metal atom contained in the metal compound may consist of atoms of one element or two or more elements, but in view of the fact that the etching rate when etching an inorganic film for transference after forming a fine pattern preferably has in-plane uniformity in the order of nanometer, the metal atoms are preferably of one element.

The metal compound (A) preferably has a metal-oxygen covalent bond.

When the metal compound contains metal-oxygen atoms, a metal-containing film formed from the composition for forming a metal-containing film is to exhibit better etching selectivity. Regarding the oxygen atom, one may be bonded to one metal atom, or multiple oxygen atoms may be bonded, but preferably, a structure in which two oxygen atoms are bonded to a metal atom is mainly contained. When a structure in which two oxygen atoms are bonded to a metal atom is mainly contained, the metal compound can have a more linear structure as in - M-O-M-O- (M being at least one kind of metal atom selected from the group consisting of Ti, Zr, and Hf), and solvent solubility can be enhanced.

To mix two substances having different properties and form a two-layer structure in one application, the difference between the free energies of the metal compound (A) and the surface modifier (B) needs to be appropriate. When the difference between the free energies is not appropriate, a so-called sea-island structure, where a matrix of one layer is interspersed with domains of the other layer, is generated in many cases, and the combination of the metal compound (A) and the surface modifier (B) is important.

As the metal compound (A) of the present invention, a commercially available metal compound may be used, and for example, it is possible to use a metal-containing compound (hereinafter, metal-containing compound (a)) having a hydrolysable group. The metal compound (A) can also be synthesized by a method of performing a hydrolysis condensation reaction of the metal-containing compound (a) etc. That is, the metal compound (A) can be a compound derived from the metal-containing compound (a). Here, a "hydrolysis condensation reaction" refers to a reaction in which a hydrolysable group contained in the metal-containing compound (a) is hydrolyzed and converted to -OH, and two -OH groups obtained undergo dehydration condensation to form -O-.

As the metal compound (A) of the present invention, it is preferable to use the metal-containing compound (a), a hydrolysis condensation reaction product of the metal-containing compound (a), or a compound which is a product of a reaction between these compounds and a material that may become a monodentate ligand or a polydentate ligand, more preferably a hydrolysis condensation reaction product of the metal-containing compound (a), or a compound which is a product of a reaction between a hydrolysis condensation reaction product of the metal-containing compound (a) and a material that may become a monodentate ligand or a polydentate ligand.

Such a metal compound (A) has a higher surface energy than the surface modifier (B), and therefore, when a resist underlayer film is formed, it is possible to achieve both high etching selectivity of the metal compound (A) and high pattern adhesiveness of the surface modifier (B) without forming a sea-island structure.

### [(a) Metal-Containing Compound]

The above-described metal-containing compound (a) is a metal compound (I) having a hydrolysable group, a hydrolysis product of the metal compound (I), a hydrolysis condensation product of the metal compound (I), or a combination of the above. In other words, the metal-containing compound (a) is derived from the metal compound (I). One kind of the metal compound (I) can be used, or two or more kinds thereof can be used in combination.

Examples of the metal compound (I) include a compound (I-1), represented by the following formula (4), etc. When such a metal compound (I-1) is contained, a stable compound (A) can be formed, and dry etching resistance can be enhanced.

LₐMX_{b} (4)

In the formula, M represents any of Ti, Zr, and Hf; L represents a monodentate ligand having 1 to 30 carbon atoms or a polydentate ligand having 1 to 30 carbon atoms; X represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

### [Hydrolysable Group]

Examples of the hydrolysable group X include halogen atoms, alkoxy groups, carboxylate groups, acyloxy groups, and -NR^{a}R^{b}. R^{a} and R^{b} each preferably independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR^{a}R^{b} include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### [Monodentate Ligand]

Examples of the monodentate ligand include a hydroxo ligand, a carboxy ligand, an amido ligand, an amine ligand, an ammonia ligand, an olefin ligand, etc.

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligand include pyridine, a trimethylamine ligand, a piperidine ligand, etc.

Examples of the olefin ligand include: linear olefins, such as ethylene and propylene; cyclic olefins, such as cyclopentene, cyclohexene, and norbornene; etc.

### [Polydentate Ligand]

Examples of the polydentate ligand include a ligand derived from a hydroxy acid ester, a ligand derived from a β-diketone, a ligand derived from a β-keto ester, a ligand derived from an α,α-dicarboxylic acid ester, a hydrocarbon having a π bond, diphosphine, etc.

Examples of the hydroxy acid ester include glycolic acid esters, lactic acid esters, 2-hydroxycyclohexane-1-carboxylic acid esters, salicylic acid esters, etc.

Examples of the β-diketone include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid ester include malonic acid diesters, α-alkyl-substituted malonic acid diesters, α-cycloalkyl-substituted malonic acid diesters, α-aryl-substituted malonic acid diesters, etc.

Examples of the hydrocarbon having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

In the general formula (4), a + b = 4, and "a" and "b" each represent an integer of 0 to 4. "a" is preferably 0 to 3, more preferably 0 to 2, further preferably 1 to 2, and particularly preferably 2. "b" is preferably 2 to 4, more preferably 2 or 3, and further preferably 2. By setting "a" and "b" to be within the above ranges, the stability of the metal compound (A) can be enhanced.

As the metal-containing compound (a), a metal alkoxide that has undergone neither hydrolysis nor hydrolysis condensation or a metal alkoxide that has a ligand and has not undergone hydrolysis condensation is preferable.

Examples of the metal-containing compound (a) include: compounds containing titanium, such as diisopropoxybis(2,4-pentanedionate)titanium(IV), tetra-n-butoxytitanium(IV), tetra-n-propoxytitanium(IV), tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV); compounds containing zirconium, such as dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono(2,4-pentanedionate)zirconium(IV), triisopropoxymono(2,4-pentanedionate) zirconium(IV), tri(3-methacryloxypropyl)methoxyzirconium(IV), and tri(3-acryloxypropyl)methoxyzirconium(IV); and compounds containing hafnium, such as diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV).

At the time of the synthesis reaction of the metal compound (A), a compound that may become a monodentate ligand or a polydentate ligand (hereinafter, compound (b) for forming a ligand) in the metal compound (A) can be contained besides the metal-containing compound (a).

Examples of the compound (b) for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the L in the formula (4). Examples also include compounds having a compound having multiple hydroxy groups etc.

Furthermore, the compound (b) for forming a ligand may be an organic compound having 1 to 30 carbon atoms and containing at least one crosslinking group represented by any of the following general formulae (a-1) to (a-4), (b-1) to (b-4), and (c-1) to (c-3).

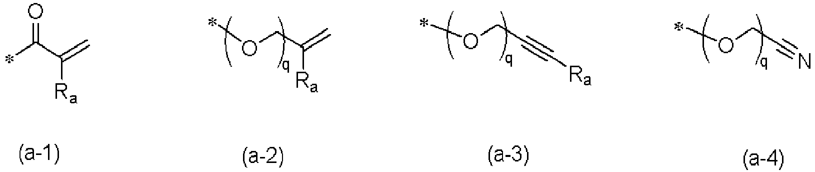

In the general formulae (a-1) to (a-4), Rₐ represents a hydrogen atom or a monovalent organic group having 1 to 10 carbon atoms, "q" represents 0 or 1, and "*" represents an attachment point.

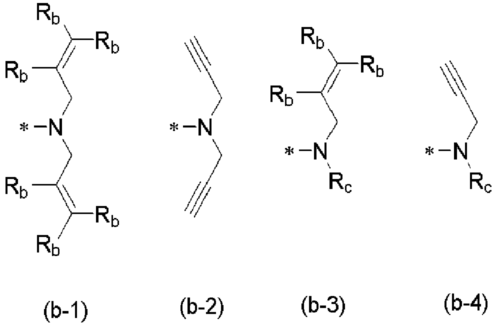

In the general formulae, R_{b}s each represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

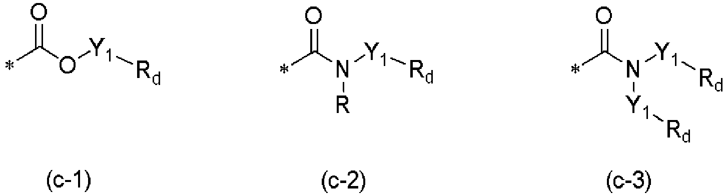

In the general formulae (c-1) to (c-3), Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R_{d} represents an organic group whose protecting group is to be removed by an action of an acid, heat, or both to generate one or more hydroxy groups or carboxy groups, R_{d} being represented by one of the following general formulae (c-4), and "*" represents an attachment point.

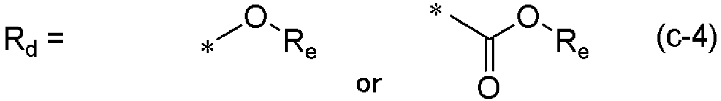

In the general formulae (c-4), Rₑ represents an organic group whose protecting group is to be removed by an action of an acid, heat, or both, and "*" represents an attachment point to Y₁.

It can be conjectured that when the compound (b) for forming a ligand contains at least one crosslinking group represented by any of the (a-1) to (a-4), (b-1) to (b-4), and (c-1) to (c-3), sufficient thermal flowability can be achieved at the time of film formation, and therefore, when a metal-containing film is formed, it is possible to achieve both higher etching selectivity of the metal compound (A) and higher pattern adhesiveness of the surface modifier (B) without a sea-island structure being formed.

From the viewpoints of the productivity and stability of the metal compound (A), the compound (b) for forming a ligand is more preferably a compound derived from a carboxy ligand, a compound derived from a ligand derived from a β-diketone, or a compound having a compound having a plurality of hydroxy groups. One kind of these compounds may be used, or two or more kinds thereof may be used in combination.

Examples of the compound derived from a carboxy ligand include compounds represented by the following formula (5).

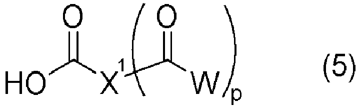

In the general formula (5), "p" represents 0 or 1. When "p" is 1, X¹ represents a divalent organic group having 2 to 20 carbon atoms, and W represents an alkoxy group having 1 to 10 carbon atoms, the following general formula (5-A), or any of the general formulae (b-1) to (b-4). When "p" is 0, X¹ represents a monovalent organic group having 8 to 30 carbon atoms and containing an aromatic ring and a crosslinking group of either of the structures represented by the general formulae (a-2) and (a-3) .

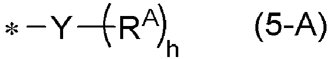

In the general formula (5-A), Y represents a saturated divalent organic group having 1 to 20 carbon atoms or an unsaturated divalent organic group having 2 to 20 carbon atoms; R^{A} represents any of the structures represented by the general formulae (a-1) to (a-4); "h" represents 1 to 6; and "*" represents an attachment point to a carbon atom of a carbonyl group.

A compound derived from a carboxy ligand having such a structure can improve the thermosetting property of the metal compound (A), and makes it possible to form a metal-containing film excellent in resistance against mixing with a resist upper layer film.

In the general formula (5), "p" is preferably 1, and W preferably has a structure represented by one of the following general formulae (5-B).

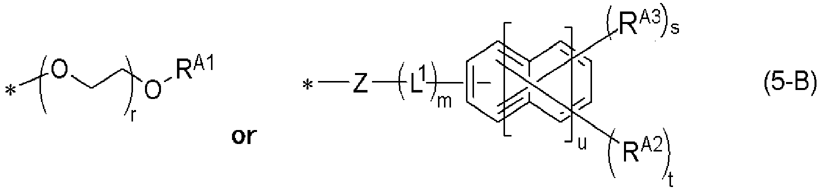

In the general formulae (5-B), R^{A1} represents a structure represented by the general formula (a-1), R^{A2} represents either of the structures represented by the general formulae (a-2) and (a-3); Z represents an oxygen atom or a secondary amine; L represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t" represents 1 to 6 and "s" represents 0 to 5, provided that t+s is 1 or more and 6 or less; "r" represents 1 to 10; "u" represents 0 or 1; "m" represents 0 or 1; and "*" represents an attachment point to a carbon atom of a carbonyl group.

A compound derived from a carboxy ligand having such a structure can improve the heat resistance of the metal compound (A), and therefore, a formed metal-containing film exhibits excellent film-formability, and it is also possible to suppress the generation of sublimation products during heat-curing and, therefore, to prevent the contamination of equipment.

In the general formula (5), it is preferable that "p" represents 1, W represents an alkoxy group having 1 to 10 carbon atoms, and X¹ represents any of the structures represented by the following general formulae (5-C) .

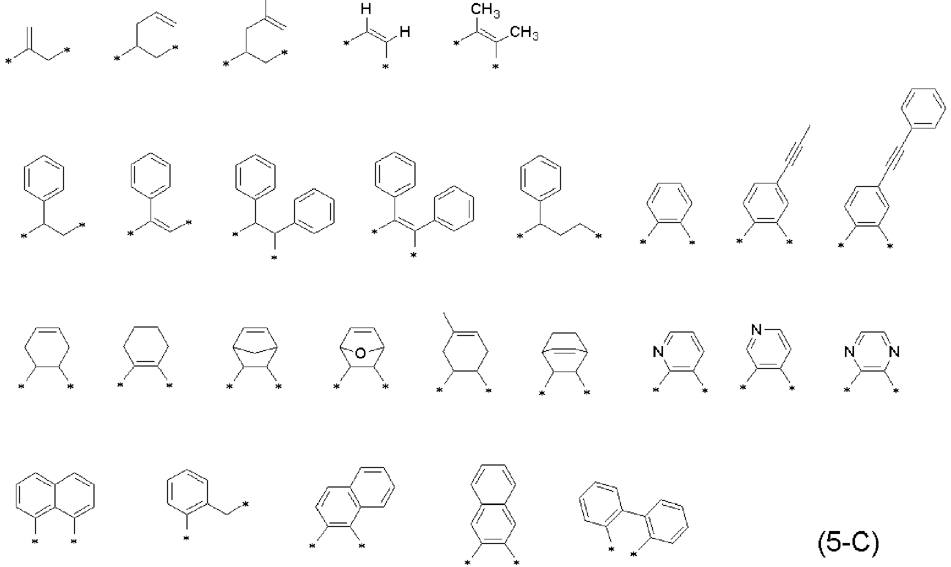

A compound derived from a carboxy ligand having such a structure can improve the heat resistance of the metal compound (A), and therefore, a formed metal-containing film exhibits excellent film-formability, and it is also possible to suppress the generation of sublimation products during heat-curing and, therefore, to prevent the contamination of equipment.

Alternatively, in the general formula (5), it is also preferable that "p" is 0, and X¹ is one of the structures represented by the following general formulae (5-D) .

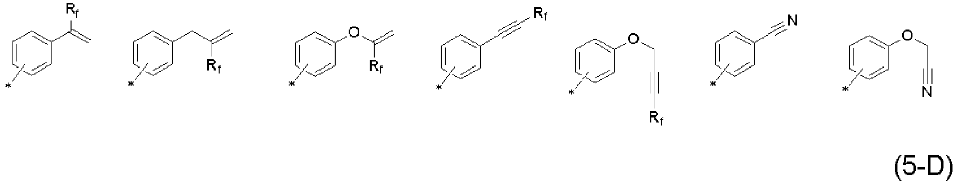

In the general formulae (5-D), R_{f} is as defined in the general formula (a-2) or (a-3); and "*" represents an attachment point to a carbon atom of a carbonyl group.

Examples of the compound derived from a carboxy ligand include compounds represented by the following formula (6).

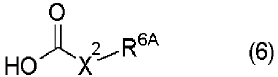

In the general formula (6), X² represents a divalent organic group having 1 to 31 carbon atoms; and R^{6A} represents any of the general formulae (c-1) to (c-3).

In the general formula (6), X² represents a divalent organic group having 1 to 31 carbon atoms, and in view of thermosetting property, preferably represents a saturated hydrocarbon having 1 to 20 carbon atoms or an unsaturated hydrocarbon having 2 to 20 carbon atoms.

In the general formulae (c-1) to (c-3), Y₁ represents a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, and Y₁ preferably represents a saturated hydrocarbon having 1 to 20 carbon atoms or an unsaturated hydrocarbon having 2 to 20 carbon atoms.

When the Y₁ in the general formulae (c-1) to (c-3) represents a saturated hydrocarbon having 1 to 20 carbon atoms or an unsaturated hydrocarbon having 2 to 20 carbon atoms, the thermosetting property of the metal compound (A) can be improved further. This is also desirable from the viewpoint of the availability of raw materials.

Specific examples of Y₁ include the following structures, but are not limited thereto.

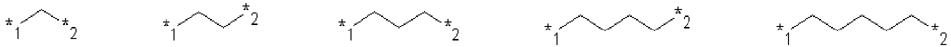

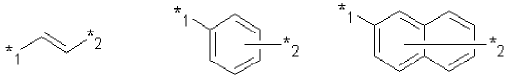

"*₁" represents an attachment point to an oxygen atom or a nitrogen atom; and "*₂" represents an attachment point to R_{d}.

The Rₑ in the general formula (c-4) represents an organic group whose heat/acid-labile group is to be removed by an action of an acid, heat, or both, preferably represents a tertiary hydrocarbyl group, or a group that forms an acetal structure together with an adjacent oxygen atom, and particularly preferably represents a tertiary hydrocarbyl group. As the tertiary hydrocarbyl group, those having 4 to 20 carbon atoms are preferable, and in particular, those having fewer carbon atoms are more preferable.

Examples of the compound derived from a ligand derived from a β-diketone include compounds represented by the following formula (7).

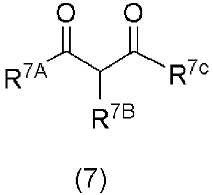

In the general formula, R^{7A} to R^{7c} each represent a hydrogen atom or a monovalent organic group having 1 to 20 carbon atoms and optionally containing a crosslinking group represented by any of the general formulae (a-1) to (a-4) and (b-1) to (b-4).

The compounds of the general formula (7) preferably contain at least one crosslinking group represented by any of the general formulae (a-1) to (a-4) and (b-1) to (b-4). Such a compound is capable of improving the thermosetting property of the metal compound (A) further, and is therefore preferable.

Examples of the compound having multiple hydroxy groups include dihydric alcohols represented by any of the formulae (7-A) to (7-C) etc.

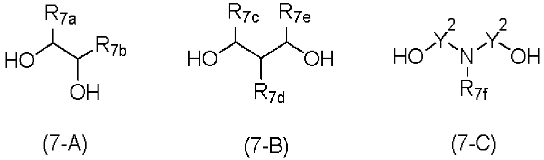

In the general formulae, R₇ₐ to R_{7b} each represent a hydrogen atom or a monovalent organic group having 1 to 20 carbon atoms and optionally containing a crosslinking group represented by any of the general formulae (a-1) to (a-4); R_{7c} to R_{7f} each represent a hydrogen atom or a monovalent organic group having 1 to 20 carbon atoms and optionally containing a crosslinking group represented by any of the following general formulae (a-1) to (a-4) and (b-1) to (b-4); and Y² represents a divalent organic group having 1 to 10 carbon atoms. In the general formula (7-A), the adjacent R₇ₐ and R_{7b} may be bonded to each other to form an unsaturated or saturated cyclic structure.

The compounds of the general formulae (7-A) to (7-C) preferably contain at least one crosslinking group represented by any of the general formulae (a-1) to (a-4) and (b-1) to (b-4). Such a compound is capable of improving the thermosetting property of the metal compound (A) further, and is therefore preferable.

In the metal compound (A), the ligand derived from the compound (b) for forming a ligand is preferably contained in an amount of 10 mol% to 90 mol%, more preferably 20 mol% to 80 mol% of the total amount of ligands coordinated to the metal atoms. Ligands other than the ligand of the compound (b) for forming a ligand, for example, a ligand derived from an alkoxy group having 1 to 10 carbon atoms, are preferably contained in an amount of 0 mol% to 50 mol%, more preferably 0 mol% to 20 mol% of the total amount of ligands coordinated to the metal atoms.

Furthermore, on the occasion of the synthesis reaction of the metal compound (A), a silicon-containing compound (c) may be added besides the metal-containing compound (a) and the compound (b) for forming a ligand.

By substituting a hydrolysable group of the metal-containing compound (a) with the silicon-containing compound (c), it is possible to enhance the stability of the metal compound (A) in the composition for forming a metal-containing film.

Examples of the silicon-containing compound (c) include structures of the following formula (s).

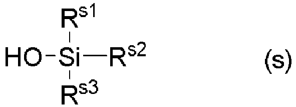

In the (s), R^{s1}, R^{s2}, and R^{s3} each represent any organic group selected from: an organic group having 1 to 30 carbon atoms and having a crosslinking group of any of the structures represented by the following general formulae (s-1) to (s-3); a substituted or unsubstituted alkyl group having 1 to 20 carbon atoms; and an aryl group having 1 to 20 carbon atoms.

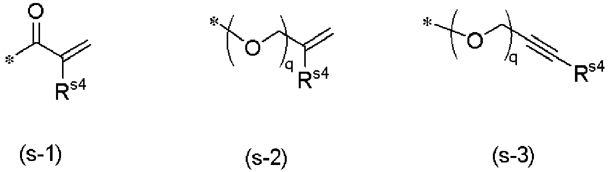

In the general formulae (s-1) to (s-3), R^{s4} represents a hydrogen atom or a monovalent organic group having 1 to 10 carbon atoms; "q" represents 0 or 1; and "*" represents an attachment point.

The silicon-containing compound (c) is preferably a compound represented by one of the following formulae, and from the viewpoint of productivity, trimethylsilanol is more preferable.

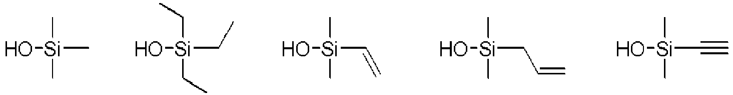

When the metal compound (A) contains the ligand derived from the compound (b) for forming a ligand and the ligand derived from the silicon-containing compound (c), the amount of the ligand derived from the compound (b) for forming a ligand contained in the metal compound (A) is preferably 10 mol% to 90 mol%, more preferably 20 mol% to 80 mol% of the total amount of ligands coordinated to the metal atoms. The ligand derived from the silicon-containing compound (c) is preferably contained in an amount of 10 mol% to 90 mol%, more preferably 20 mol% to 80 mol% of the total amount of ligands coordinated to the metal atoms. Ligands other than the ligands of the compound (b) for forming a ligand and the silicon-containing compound (c), for example, a ligand derived from an alkoxy group having 1 to 10 carbon atoms, are preferably contained in an amount of 0 mol% to 50 mol%, more preferably 0 mol% to 20 mol% of the total amount of ligands coordinated to the metal atoms.

When a metal compound (A) containing a ligand derived from the compound (b) for forming a ligand is to be synthesized, the synthesis method is not particularly limited as long as the metal compound (A) contains the ligand derived from the compound (b) for forming a ligand. For example, a metal alkoxide or a metal acetylacetonate (acac) can be used as the metal-containing compound (a), and the metal compound (A) can be obtained by allowing the alkoxy or acac metal to react with the compound (b). The metal-containing compound (a) may be subjected to hydrolysis condensation and then the product may be allowed to react with the compound (b) for forming a ligand, or the metal-containing compound (a) may be allowed to react with the compound (b) and then the product may be subjected to hydrolysis condensation. If it is difficult to control the hydrolysis condensation, the reaction with the compound (b) may be performed in a non-hydrous environment. The method is preferably adjusted appropriately in accordance with the properties required in the metal compound (A) and the metal-containing film. When the silicon-containing compound (c) and the compound (b) for forming a ligand are to be contained as ligands, it is preferable to allow the metal-containing compound (a) and the silicon-containing compound (c) to react and then allow the product to react with the compound (b) for forming a ligand.

As a method for performing a hydrolysis condensation reaction using the metal-containing compound (a), examples include a method of subjecting the metal-containing compound (a) to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the metal-containing compound (a) etc., on the molar basis. The upper limit of the amount of the water is preferably 20-fold, more preferably 15-fold, and further preferably 10-fold on the molar basis.

The solvent used in the synthesis reaction of the metal compound (A) is not particularly limited, and for example, a solvent given as an example of the solvent (C) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### [(B) Surface Modifier]

The surface modifier contained in the inventive composition for forming a metal-containing film is a polymer (polymer compound) containing one or both of a repeating unit represented by the following general formula (1) and a repeating unit represented by the following general formula (2). Furthermore, the polymer does not contain a repeating unit containing a hydroxy group.

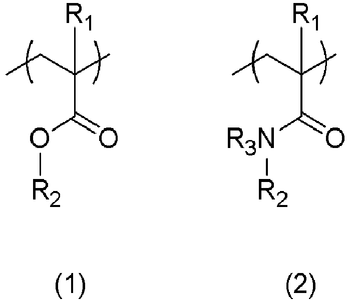

In the formulae, R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.

Such a surface modifier (B) has lower a surface energy than the metal compound (A), and therefore, when a metal-containing film is formed, it is possible to achieve both high etching selectivity by virtue of the metal compound (A) and high pattern adhesiveness by virtue of the surface modifier (B) without forming a sea-island structure.

The R₃ is preferably a hydrogen atom.

The heterocyclic structure contained in the R₂ of the polymer containing the repeating unit represented by the general formula (1) or (2) is preferably a heterocyclic structure containing an oxygen atom.

When such a heterocyclic structure is contained, higher adhesiveness to a resist pattern can be achieved, and therefore, the structure is further effective for preventing a fine-resist pattern from collapsing.

The R₂ is preferably a monovalent organic group containing a group selected from the following formulae (R₂-1) to (R₂-3).

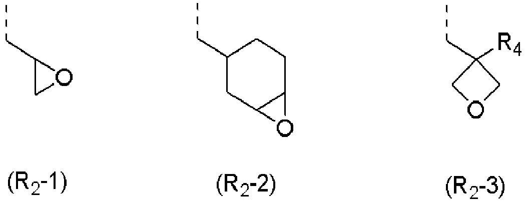

In the formulae, R₄ represents a hydrogen atom or an alkyl group having 1 to 10 carbon atoms; and a broken line represents an attachment point.

When such a heterocyclic structure is contained, the epoxy or oxetane structure undergoes a ring-opening reaction during heating for film formation, and thus, the film is cured. Moreover, the hydroxy groups generated by this ring-opening reaction also contribute to improvement in adhesiveness to a resist upper layer film.

The R₄ in the formula (R₂-3) is preferably a hydrogen atom, a methyl group, or an ethyl group, and an ethyl group is more preferable.

As specific examples of the repeating units represented by the formulae (1) and (2), the following structures are favorable.

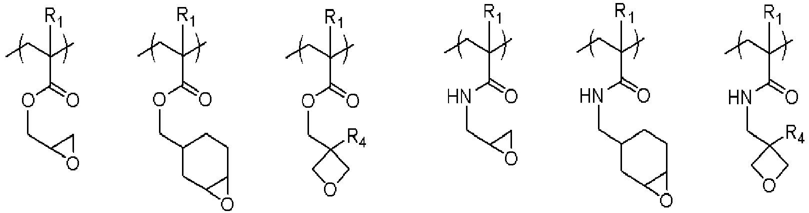

R₁ and R₄ are as defined above.

Note that one kind of the repeating unit represented by the general formula (1) or the general formula (2) may be contained in the polymer of the surface modifier (B), or two or more kinds thereof may be contained.

The polymer contained in the surface modifier (B) preferably contains the repeating units represented by the general formula (1) and/or the general formula (2) in a percentage of 30 mol% or more, more preferably 50 mol% or more relative to all the repeating units.

In addition, the polymer contained in the surface modifier (B) preferably contains the repeating units represented by the general formula (1) and/or formula (2) in a percentage of 95 mol% or less, more preferably 90 mol% or less relative to all the repeating units.

When one or both of the repeating units represented by the general formula (1) and the general formula (2) are contained in such a proportion, the polarity of the polymer can be adjusted, and excellent adhesiveness to a resist pattern can be achieved. Moreover, the epoxy or oxetane structure of the general formulae (1) and (2) undergoes a ring-opening reaction during heating for film formation and the film cures, and therefore, a dense adhesive film can be formed, making it possible to prevent intermixing between the adhesive film and a resist upper layer film. In this manner, it is possible to prevent the generation of residue in space portions of a pattern, and a pattern having high rectangularity can be obtained. Accordingly, in the surface modifier (B), the repeating units represented by the general formulae (1) and (2) are preferably contained in a proportion of 30 mol% or more and 95 mol% or less, particularly preferably 50 mol% or more and 90 mol% or less relative to all the repeating units.

The surface modifier is preferably a polymer further containing any repeating unit represented by the following formula (3a) or formula (3b).

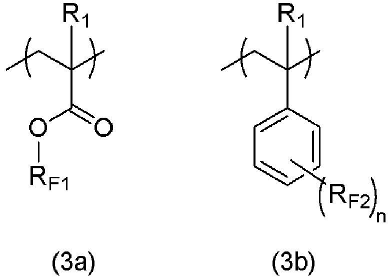

In the formulae, R_{F1} represents a monovalent organic group having 1 to 20 carbon atoms and containing at least one F atom; R_{F2} represents an F atom or a monovalent organic group having 1 to 10 carbon atoms and containing one or more F atoms; R₁ represents a hydrogen atom or a methyl group; and "n" represents 1 to 5.

When the polymer contains any repeating unit represented by the formula (3a) or (3b), it is easier for the surface modifier (B) to be distributed unevenly on a surface layer of the metal-containing film, and therefore, such a polymer is more preferable.

As specific examples of the repeating units represented by the formulae (3a) and (3b), the following structures are favorable.

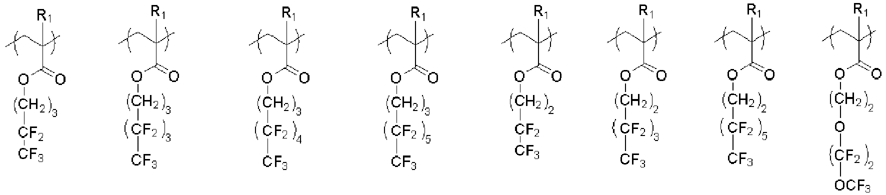

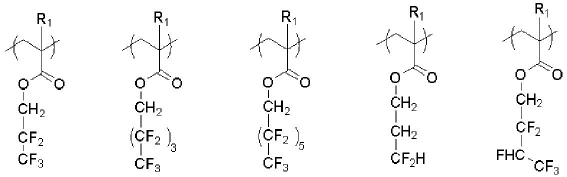

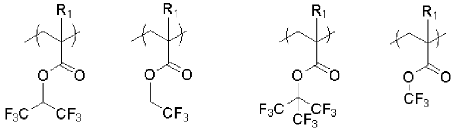

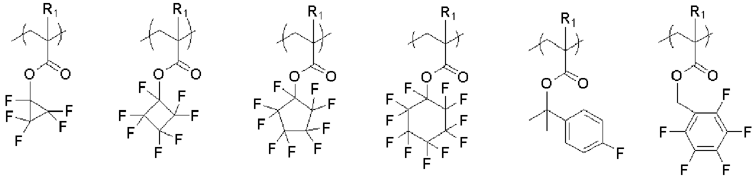

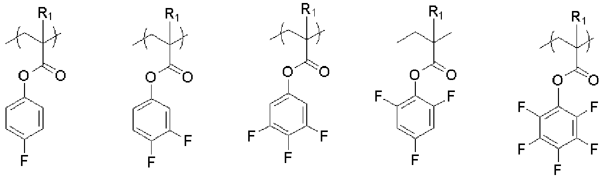

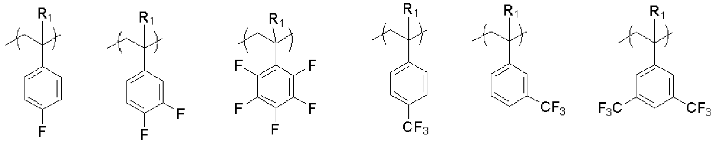

R₁ is as defined above.

Note that one kind of the repeating units represented by the general formulae (3a) and (3b) may be contained in the polymer (B), or two or more kinds thereof may be contained.

The polymer, being the surface modifier (B), preferably contains the repeating units represented by the general formula (1) and/or (2) in a percentage of 30 mol% or more and 95 mol% or less, more preferably 50 mol% or more and 90 mol% or less relative to all the repeating units. In addition, the repeating units represented by the general formula (3a) and/or (3b) are preferably contained in a percentage of 5 mol% or more and 70 mol% or less, more preferably 10 mol% or more and 50 mol% or less.

Furthermore, the surface modifier (B) preferably further has a repeating unit represented by the following general formula (B-1).

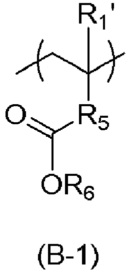

In the formula, R₁^{'} represents a hydrogen atom or a methyl group; R₅ represents a single bond or a divalent linking group having 2 to 10 carbon atoms and containing an ester group; and R₆ represents a saturated or unsaturated tertiary alkyl group having 4 to 20 carbon atoms.

In the general formula (B-1), R₅ represents a single bond or a divalent linking group having 2 to 10 carbon atoms and containing an ester group. Specific examples of R₅ include a single bond, -CO₂CH₂-, -CO₂CH₂CH₂-, -CO₂CH₂CH₂CH₂-, -CO₂CH(CH₃)-, -CO₂CH₂CH₂CH₂CH₂-, -CO₂CH₂CH₂CH₂CH₂CH₂-, -CO₂CH₂CH₂CH₂CH₂CH₂CH₂CH₂CH₂-, -CO₂CH₂CH₂O-, -CO₂CH₂CH₂OCH₂CH₂O-, -CO₂CH₂CH₂OCH₂CH₂OCH₂CH₂O-, etc. In particular, -CO₂CH₂-, -CO₂CH₂CH₂-, -CO₂CH₂CH₂CH₂-, -CO₂CH₂CH₂CH₂CH₂-, and -CO₂CH₂CH₂CH₂CH₂CH₂- are particularly preferable.

Specific examples of the R₆ in the repeating unit represented by the general formula (B-1) include the following structures, but are not limited thereto. A broken line represents an attachment point.

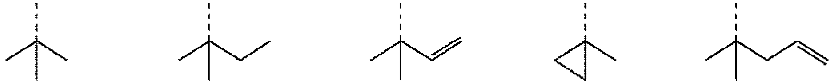

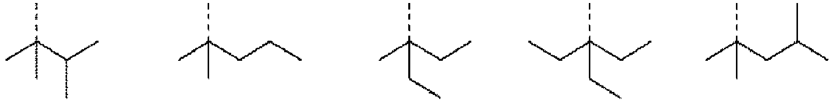

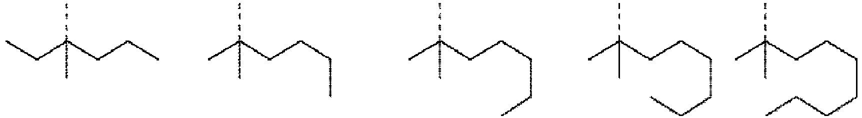

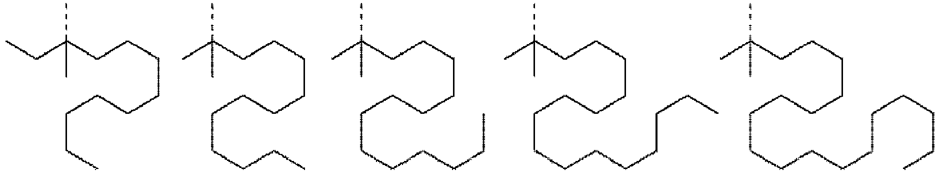

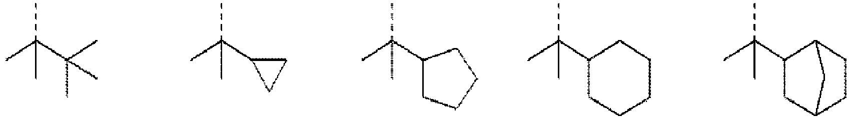

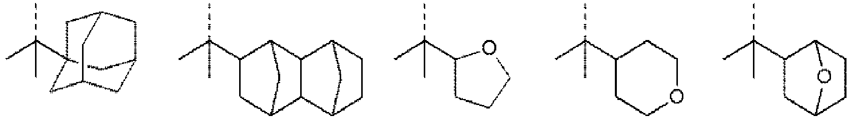

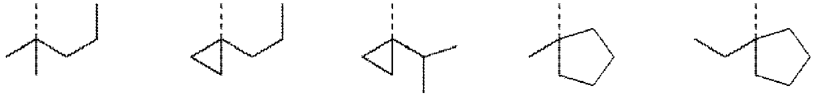

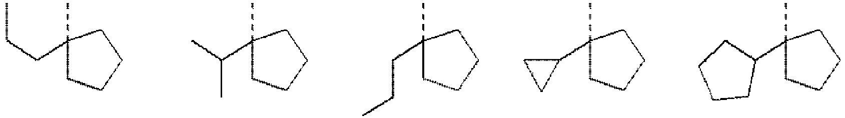

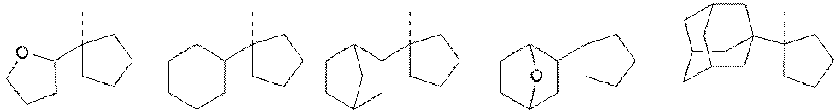

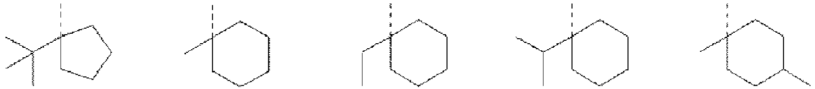

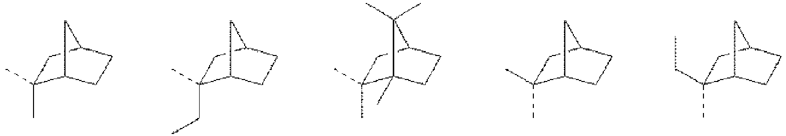

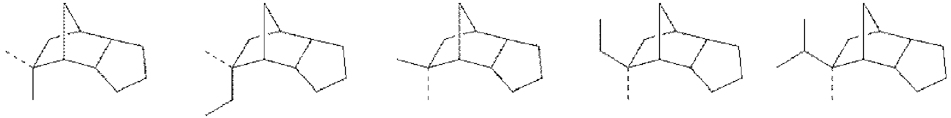

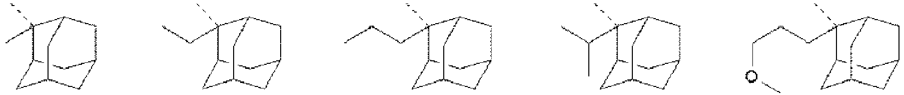

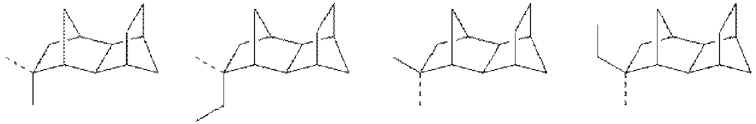

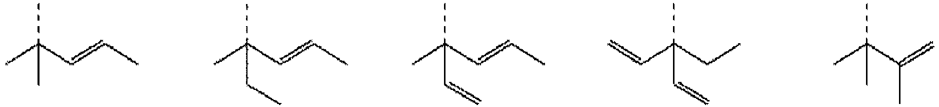

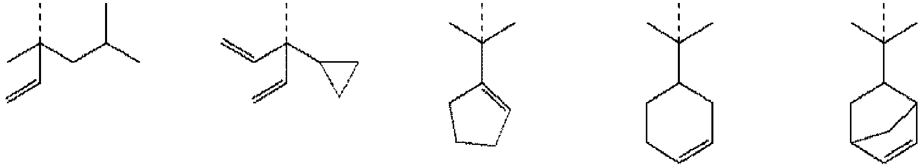

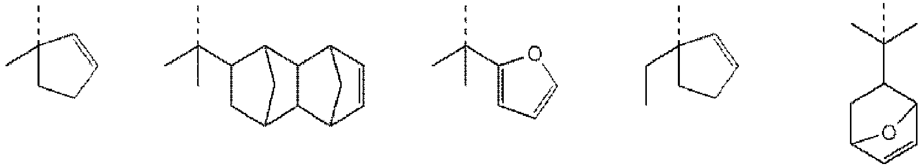

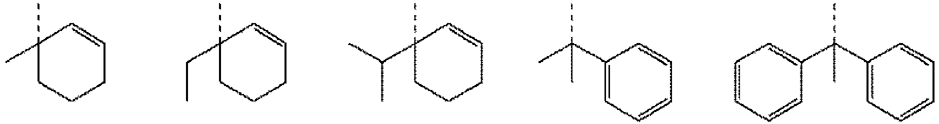

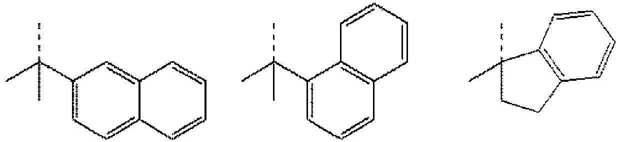

When a metal-containing film is formed from a composition for forming a metal-containing film containing a polymer containing the repeating unit represented by the general formula (B-1), an elimination-decomposition reaction of the tertiary alkyl group R₆ progresses due to the action of heat and/or an acid generated by an acid generator described later, and a carboxylic acid is generated. By virtue of the polarity of this carboxylic acid, the adhesiveness to a resist pattern is improved, the rectangularity of a pattern is improved and the generation of a residue in a space portion of a pattern is prevented.

In addition, the generated carboxylic acid undergoes a ring-opening addition reaction with the repeating unit represented by the general formula (1) and/or (2) to form a hydroxyester crosslinking structure in some cases. A typical example of a reaction is shown below. In the following formula, (B-2) is the state where the R₆ in the repeating unit (B-1) has been eliminated to form a carboxylic acid, and (B-3) is the state where a ring-opening addition reaction has taken place between (B-2) and (1"), which is an example of the general formulae (1) and (2), to form a hydroxyester crosslinking structure. The moiety surrounded by the dotted line is the hydroxyester crosslinking structure formed by this reaction.

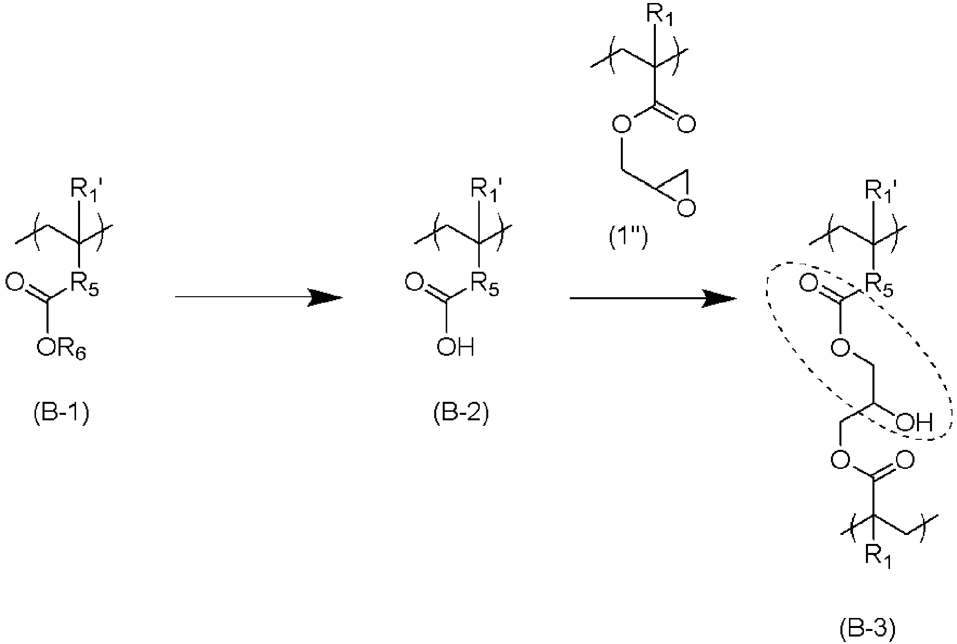

In the formulae, R₁, R₅, R₆, and R₁' are as defined above.

The formation of this hydroxyester crosslinking structure is a crosslinking reaction, and promotes the curing of the adhesive film. A dense film can be formed by sufficient curing and intermixing between the adhesive film and the resist upper layer film can be prevented, and this makes it possible to prevent residues in a space portion of a pattern and to obtain a highly rectangular pattern.

Furthermore, the hydroxyester crosslinking structure is a polar group, and interacts with the resist pattern, and therefore, the presence of the repeating unit (B-1) also contributes to the prevention of resist pattern collapse.

Note that one kind of the repeating unit represented by the general formula (B-1) may be contained in the polymer (B), or two or more kinds may be contained.

When the polymer (B) contains the repeating unit represented by the formula (B-1), the repeating unit represented by the formula (B-1) is preferably contained in a percentage of 1 mol% or more and 30 mol% or less, preferably 5 mol% or more and 15 mol% or less relative to all the repeating units of the polymer (B).

Furthermore, in the present invention, the polymer (B) does not contain a constitutional unit containing a hydroxy group.

If the polymer contains a hydroxy group, there is risk of the stability of the metal compound being degraded, and therefore, such a polymer is no favorable.

The polymer (B) preferably has a weight-average molecular weight of 6,000 to 50,000, and preferably has a dispersity, which is expressed as "weight-average molecular weight"/"number-average molecular weight", of 3.0 or less.

Note that the "weight-average molecular weight" mentioned here is a value measured by gel permeation chromatography (GPC) using tetrahydrofuran as an eluent and polystyrene as a standard substance. When the weight-average molecular weight and the dispersity of the polymer contained as the surface modifier (B) in the composition for forming a metal-containing film are in such ranges, excellent film-formability can be achieved at the time of spin-coating, and the generation of sublimation products can be suppressed at the time of heat-curing, so that equipment can be prevented from being contaminated. In particular, in a case where a metal-containing film is formed as a resist middle layer film, the in-plane film thickness distribution of a substrate to be processed tends to be uneven if the composition contains a component that has a low molecular weight and is volatile, but when the molecular weight and the dispersity of the used polymer is set as described above to control the amount of low-molecular-weight components in the composition, the in-plane film thickness distribution of the substrate to be processed can be kept low. Accordingly, the polymer included in the surface modifier (B) contained in the inventive composition for forming a metal-containing film preferably has a weight-average molecular weight of 6,000 to 50,000, particularly preferably 8,000 to 40,000. The dispersity is preferably 3.0 or less.

The surface modifier (B) contained in the composition for forming a metal-containing film is preferably contained in a proportion of 1 part by mass or more and 50 parts by mass or less, more preferably 5 parts by mass or more and 30 parts by mass or less relative to 100 parts by mass of the metal compound (A).

When the contained proportion is as described, it is possible to achieve both higher etching selectivity of the metal compound (A) and higher pattern adhesiveness of the surface modifier (B).

As a method for synthesizing the polymer for the surface modifier (B), examples include a method of: mixing monomers each having a polymerizable unsaturated bond corresponding to each repeating unit; and adding a radical polymerization initiator to perform thermal polymerization in a solvent. Regarding polymerization conditions, various conditions can be selected depending on the used monomers, target molecular weight, etc., and there are no particular limitations. Specific examples of the solvent to be used in the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, butyl acetate, diacetone alcohol, etc. Examples of the radical polymerization initiator include 2,2'-azobisisobutyronitrile (AIBN), 2,2'-azobis(2,4-dimethylvaleronitrile), dimethyl-2,2-azobis(2-methylpropionate), benzoyl peroxide, lauroyl peroxide, etc. It is also possible to add, as a chain transfer agent at the time of the polymerization, a thiol such as octanethiol and 2-mercaptoethanol. The polymerization reaction can be performed favorably while heating at 40°C to the boiling point of the reaction solvent. The reaction time is preferably 0.5 to 100 hours, more preferably 1 to 48 hours.

For example, it is possible to synthesize a polymer containing the repeating units represented by the general formulae (1), (2), and (B-1) by performing the above-described polymerization using, as monomers, compounds represented by the following general formulae (1'), (2'), and (B-1'), each having a polymerizable double bond.

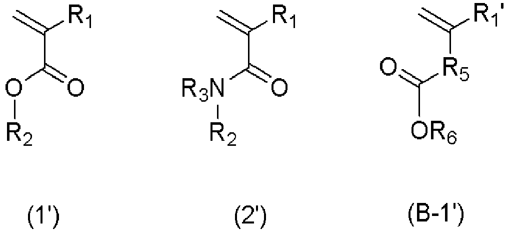

In the formulae, R₁ to R₃, R₅, R₆, and R₁' are as defined above.

On the occasion of the polymerization, all ingredients may be mixed together and then heated; alternatively, into part of the ingredients that has been heated beforehand, the remaining ingredients may be added at once or gradually, separately or together in mixture. For example, a polymerization method in which a polymerization solvent alone is heated and then a monomer solution and a polymerization initiator solution are added thereto separately and gradually makes it possible to obtain a comparatively homogeneous polymer, and can also prevent abnormal reactions such as a runaway reaction. Therefore, such a method is particularly favorable.

The polymer solution obtained by the above method may be contained in a composition for forming a metal-containing film as it is, or, if necessary, the solution may be purified by a conventional method, such as crystallization, liquid-liquid separation, filtration, and concentration, to remove remaining monomers, remaining solvent, reaction by-products, other impurities, etc. When the polymer is to be purified, suitable methods are: a crystallization method where a poor solvent, such as water, aqueous alcohol, and saturated hydrocarbon, is added to the solution of the polymer, and the generated precipitate is collected by filtration; and a liquid-liquid separation method where a poor solvent layer is separated and removed. In particular, the liquid-liquid separation method is particularly suitable. When the polymer is purified by the liquid-liquid separation method, low-molecular-weight components in the polymer solution can be removed efficiently, and therefore, when a metal-containing film is formed with a composition for forming a metal-containing film containing the polymer, the generation of sublimation products is reduced. As a result, the contamination of a film-forming apparatus can be prevented.

### <(C) Solvent>

The solvent (C) usable in the inventive composition for forming a metal-containing film is not particularly limited as long as the solvent is capable of dissolving the metal compound (A), the surface modifier (B), and when contained, (D) a thermal acid generator, (E) a photo-acid generator, (F) a crosslinking agent, (G) a surfactant, other additives, etc. described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts, more preferably 250 to 5,000 parts relative to 100 parts by mass of the metal compound (A).

### <(C-1) High-Boiling-Point Solvent>

In the inventive composition for forming a metal-containing film, the solvent (C) may contain a high-boiling-point organic solvent (C-1).

The high-boiling-point organic solvent (C-1) may be one or more organic solvents having a boiling point of 180 degrees (°C) or higher.

For example, as the solvent (C), the composition may contain a mixture of one or more organic solvents having a boiling point of lower than 180°C and one or more organic solvents having a boiling point of 180°C or higher (high-boiling-point solvent (C-1)).

The high-boiling-point solvent (C-1) is not particularly limited to hydrocarbons, alcohols, ketones, esters, ethers, or chlorine-based solvents, as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (C-1) may be selected suitably from the solvents above, for example, depending on the temperature at which the inventive composition for forming a metal-containing film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, when a resist underlayer film is formed, it is possible to achieve both higher etching selectivity by virtue of the metal compound (A) and higher pattern adhesiveness by virtue of the surface modifier (B) without forming a sea-island structure. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (C-1) is used, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### <Other Components>

When the composition for forming a metal-containing film is usable as a resist underlayer film used in a multilayer resist method, one or more kinds of the metal compound (A), one or more kinds of the surface modifier (B), and one or more kinds of the solvent (C) can be contained, and as necessary, the composition may contain at least one of a thermal acid generator (D), a photo-acid generator (E), a crosslinking agent (F), and a surfactant (G).

In the following, components that may be contained in the composition of the present invention for forming a resist underlayer film other than the metal compound (A), the surface modifier (B), and the organic solvent (C) will be described.

### [(D) Thermal Acid Generator]

In the inventive composition for forming a metal-containing film, a thermal acid generator (D) is preferably contained to promote a crosslinking reaction by heat.

Examples of a thermal acid generator (D) usable in the inventive composition for forming a metal-containing film include the following general formula (7) etc.

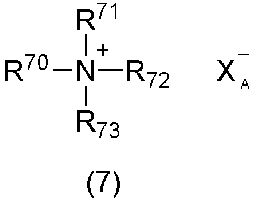

In the formula, X_{A}⁻ represents a non-nucleophilic counter ion. R⁷⁰, R⁷¹, R⁷², and R⁷³ each represent a hydrogen atom, a linear, branched, or cyclic alkyl group, alkenyl group, oxoalkyl group, or oxoalkenyl group, having 1 to 12 carbon atoms, an aryl group having 6 to 20 carbon atoms, or an aralkyl group or aryloxoalkyl group having 7 to 12 carbon atoms, part or all of the hydrogen atoms of these groups optionally being substituted with an alkoxy group or the like. In addition, R⁷⁰ and R⁷¹, or R⁷⁰, R⁷¹, and R⁷² optionally form a ring, and in a case where a ring is formed, R⁷⁰ and R⁷¹, or R⁷⁰, R⁷¹, and R⁷² represent an alkylene group having 3 to 10 carbon atoms, or a heteroaromatic ring having the nitrogen atom in the formula in the ring.

The R⁷⁰, R⁷¹, R⁷², and R⁷³ may be identical to or different from each other, and specific examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, etc.

Examples of the alkenyl group include a vinyl group, an allyl group, a propenyl group, a butenyl group, a hexenyl group, a cyclohexenyl group, etc.

Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, etc.

Examples of the oxoalkenyl group include a 2-oxo-4-cyclohexenyl group, a 2-oxo-4-propenyl group, etc.

Examples of the aryl group include a phenyl group; a naphthyl group; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkyl phenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group, etc.

Examples of the aralkyl group include a benzyl group, a phenylethyl group, a phenethyl group, etc.

Examples of the aryloxoalkyl group include 2-aryl-2-oxoethyl groups such as a 2-phenyl-2-oxoethyl group, a 2-(1-naphthyl)-2-oxoethyl group, a 2-(2-naphthyl)-2-oxoethyl group, etc.

When R⁷⁰ and R⁷¹, or R⁷⁰, R⁷¹, and R⁷² form a heteroaromatic ring having, in the ring, the nitrogen atom in the formula, examples include imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

Examples of the non-nucleophilic counter ion of X_{A}⁻include halide ions, such as chloride ion and bromide ion; fluoroalkylsulfonates, such as triflate, 1,1,1-trifluoroethanesulfonate, and nonafluorobutanesulfonate; arylsulfonates, such as tosylate, benzenesulfonate, 4-fluorobenzenesulfonate, and 1,2,3,4,5-pentafluorobenzenesulfonate; alkylsulfonates, such as mesylate and butanesulfonate; imidic acids, such as bis(trifluoromethylsulfonyl)imide, bis(perfluoroethylsulfonyl)imide, and bis(perfluorobutylsulfonyl)imide; methide acids, such as tris(trifluoromethylsulfonyl)methide and tris(perfluoroethylsulfonyl)methide; furthermore, sulfonates, represented by the following general formula (8), being fluorinated in the α-position; and sulfonates, represented by the following general formula (9), being fluorinated in the α- and β-positions.

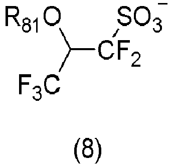

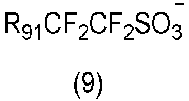

In the general formula (8), R₈₁ represents a hydrogen atom, a linear, branched, or cyclic alkyl group or acyl group having 1 to 23 carbon atoms, an alkenyl group having 2 to 20 carbon atoms, or an aryl group or aryloxy group having 6 to 20 carbon atoms. In the general formula (9), R₉₁ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the thermal acid generator include the following, but are not limited thereto.

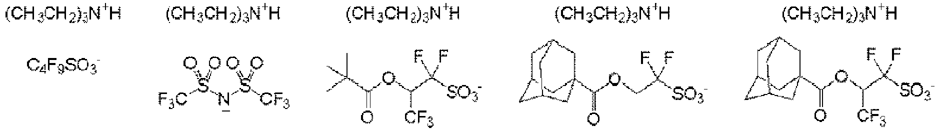

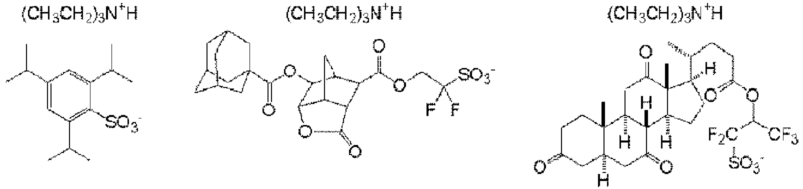

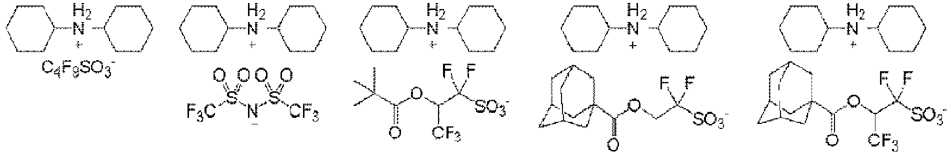

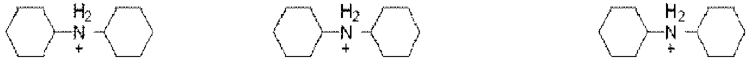

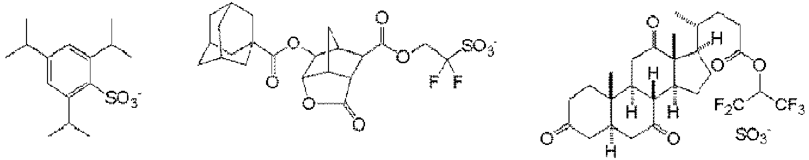

One kind of the thermal acid generator (D), contained in the inventive composition for forming a metal-containing film, may be used, or two or more kinds thereof may be used in combination. The thermal acid generator is preferably contained in an amount of 0.05 to 30 parts, more preferably 0.1 to 10 parts based on 100 parts of the surface modifier (B). When the amount is 0.05 parts or more, the amount of generated acid and crosslinking reaction are sufficient, and when 30 parts or less, there is little risk of a mixing phenomenon occurring due to an acid moving to an upper layer resist.

### [(E) Photo-Acid Generator]

The inventive composition for forming a metal-containing film can contain a photo-acid generator (E) for adjusting appropriately a pattern profile in a resist upper layer film, exposure sensitivity, etc. One kind of the photo-acid generator may be used, or two or more kinds thereof may be used in combination. As the photo-acid generator, for example, those disclosed in paragraphs [0160] to [0179] of JP2009-126940A can be used. The photo-acid generator is preferably contained in an amount of 0.05 to 30 parts, more preferably 0.1 to 10 parts based on 100 parts of the surface modifier (B). When the photo-acid generator is contained in the above-described ranges, resolution is excellent, and there is no risk of problems of foreign substances occurring after developing a resist or when removing the resist.

### [(F) Crosslinking Agent]

The inventive composition for forming a metal-containing film can also contain a crosslinking agent (F) to increase curability and further inhibit intermixing with a resist upper layer film. The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (F) can be used, or two or more kinds thereof can be used in combination, and when the crosslinking agent is contained, the contained amount is preferably 5 to 50 parts, more preferably 10 to 40 parts based on 100 parts of the surface modifier (B). When the contained amount is 5 parts or more, sufficient curability can be exhibited, and intermixing with a resist upper layer film can be suppressed. Meanwhile, when the contained amount is 50 parts or less, there are no risks of degradation in adhesiveness due to the proportion of the surface modifier (B) in the composition being low, or degradation in dry etching resistance due to the proportion of the metal compound (A) being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

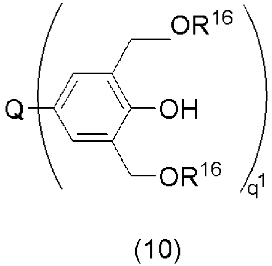

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a q¹-valent hydrocarbon group having 1 to 20 carbon atoms. "q¹" represents an integer of 1 to 5, more preferably 2 or 3. Specific examples of Q include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compounds represented by the general formula (10) include the following compounds. Among these, triphenolmethane, triphenolethane, 1,1,1,-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the adhesive film.

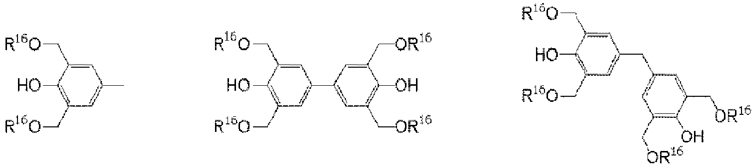

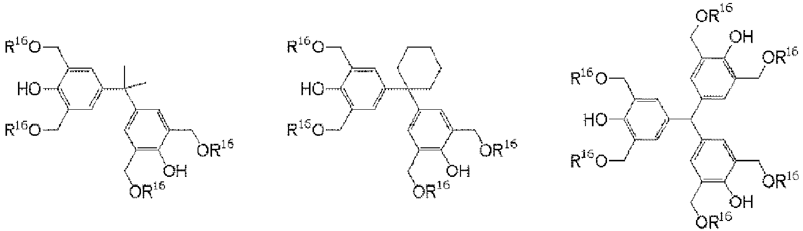

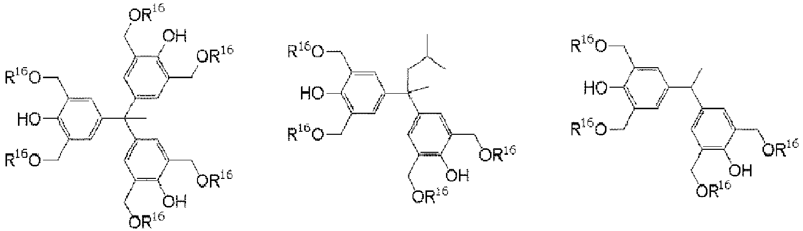

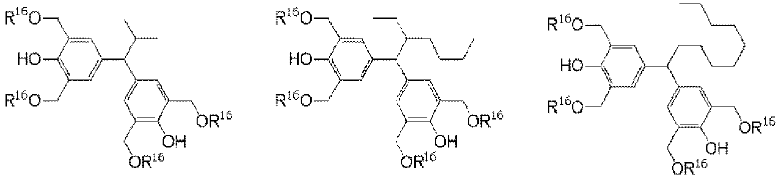

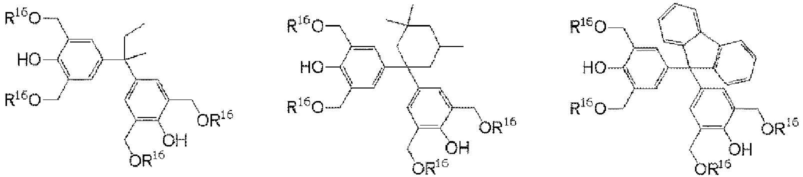

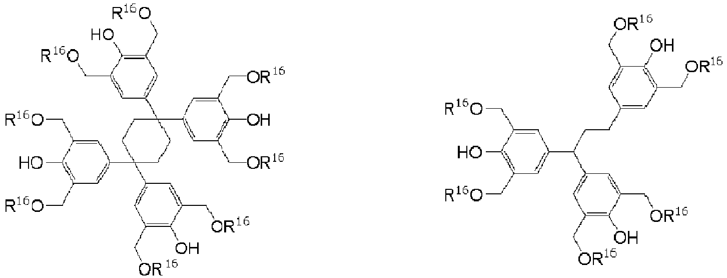

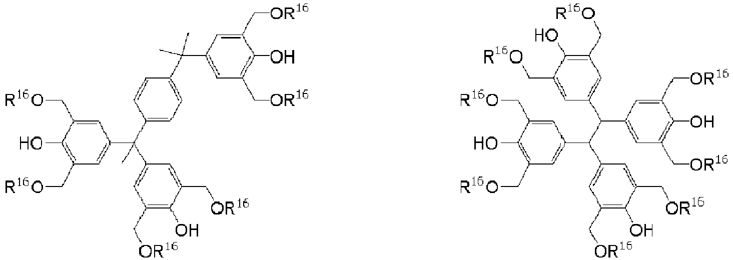

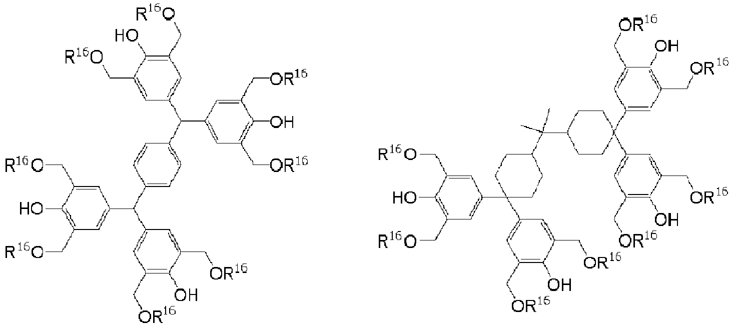

One of the crosslinking agents (F) can be used, or two or more can be used in combination. The amount of the crosslinking agent (F) to be contained is preferably 10 mass% to 50 mass%, more preferably 15 mass% to 30 mass% based on 100 parts of the surface modifier (B). When the contained amount is 10 mass% or more, sufficient curability can be provided, and intermixing with a resist upper layer film can be suppressed. Meanwhile, when the contained amount is 50 mass% or less, there are no risks of degradation in adhesiveness due to the proportion of the surface modifier (B) in the composition for forming a metal-containing film being low, or degradation in dry etching resistance due to the proportion of the metal compound (A) being low.

### [(G) Surfactant]

A surfactant (G) may be contained in the inventive composition for forming a metal-containing film in order to improve coating property in spin-coating. One surfactant can be used, or two or more surfactants can be used in combination. Examples of the surfactant include those disclosed in paragraphs [0142] to [0147] of JP2009-269953A. When the surfactant is contained, the contained amount is preferably 0.001 to 20 parts, more preferably 0.01 to 10 parts per 100 parts of the metal compound (A). When the amount is in such a range, coating property is certainly improved, and a thin, uniform, adhesive film can be formed.

### [Plasticizer]

The inventive composition for forming a metal-containing film can also contain a plasticizer. The plasticizer is not particularly limited, and various known plasticizers can be widely used. Examples include: low molecular-weight compounds, such as phthalate esters, adipate esters, phosphate esters, trimellitate esters, and citrate esters; and polymers, such as polyether polymers, polyester polymers, and polyacetal polymers described in JP 2013-253227 A. The amount of the plasticizer to be contained is preferably 1 mass% to 500 mass% based on 100 parts of the metal compound (A). When the contained amount is in such a range, the composition is excellent in filling and planarizing of a pattern.

### <Method for Forming Metal-Containing Film>

In the present invention, by using the above-described composition for forming a metal-containing film, it is possible to form, for example, a metal-containing film as a resist underlayer film of a multilayer resist film used in lithography.

In the method for forming a resist underlayer film by using the inventive composition for forming a metal-containing film, a substrate to be processed is coated with the above-described composition for forming a metal-containing film by a spin-coating method or the like. After spin-coating, baking (heating) is performed so as to evaporate the solvent and promote a crosslinking reaction to prevent mixing with a resist upper layer film. The baking is preferably performed at a temperature of 100°C or higher and 450°C or lower for 10 to 600 seconds, more preferably at 200°C or higher and 300°C or lower for 10 to 300 seconds. In consideration of influences on device damage, wafer deformation, and the like, the upper limit of the heating temperature in the wafer process of lithography is preferably not more than 450°C, and more preferably not more than 300°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By virtue of baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

Alternatively, using the above-described composition for forming a metal-containing film, it is also possible to form, for example, a metal-containing film as a middle layer film of a multilayer resist film used in lithography.

### <Patterning Process Using Composition for Forming Resist Underlayer Film>

The present invention provides, as a patterning process according to a two-layer resist process using the inventive composition for forming a metal-containing film, a patterning process for forming a pattern in a substrate to be processed, including the steps of:
(I-1) applying the inventive composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas. The metal-containing film exhibits etching resistance with respect to fluorine-based gas. Therefore, the dry etching of the substrate to be processed that is performed while using the metal-containing film as a mask is preferably performed using an etching gas mainly containing a fluorine-based gas.

The present invention also provides, as a patterning process according to a three-layer resist process using the inventive composition for forming a metal-containing film, a patterning process for forming a pattern in a substrate to be processed, including the steps of:
(II-1) forming a resist underlayer film on a substrate to be processed;
(II-2) applying the inventive composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.

The metal-containing film, formed with the inventive composition for forming a metal-containing film, used as the middle layer film in the above-described three-layer resist process exhibits etching resistance with respect to oxygen-based gas. Therefore, the dry etching of the organic resist underlayer film that is performed while using the metal-containing film as a mask in the three-layer resist process is preferably performed using an etching gas mainly containing an oxygen-based gas. The organic underlayer film exhibits etching resistance with respect to fluorine-based gas. Therefore, the dry etching of the substrate to be processed that is performed while using the organic underlayer film as a mask is preferably performed using an etching gas mainly containing a fluorine-based gas.

In the above-described patterning process, the resist upper layer film may be either a positive type or a negative type, and it is possible to use a composition similar to the typically used photoresist composition. In a case where the resist upper layer film is formed with the photoresist composition, a spin-coating method is preferable.

In a case where the resist upper layer film is formed using by a spin-coating method using a photoresist composition, prebaking is conducted after applying the resist. The prebaking is preferably performed at 60 to 180°C for 10 to 300 seconds. Thereafter, exposure is conducted according to a usual manner, followed by post-exposure baking (PEB) and development, and thereby, a resist pattern can be obtained. Although the thickness of the resist upper layer film is not particularly limited, the thickness is preferably 10 to 500 nm, particularly preferably 20 to 400 nm.

Examples of the light for exposure include high-energy beams at wavelengths of 300 nm or less, specifically, far ultraviolet rays, KrF excimer laser beam (248 nm), ArF excimer laser beam (193 nm), F₂ laser beam (157 nm), Kr₂ laser beam (146 nm), Ar₂ laser beam (126 nm), soft X-rays at 3 to 20 nm (EUV), electron beam (EB), ion beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. For example, the etching of the metal-containing film in the two-layer resist process is performed by using a chlorine-based gas while using the upper layer resist pattern as a mask. In this manner, a metal-containing film pattern is formed. Next, the substrate to be processed is etched while using the obtained metal-containing film pattern as a mask. The etching of a body to be processed may be performed according to a usual manner. For example, in the case of a body to be processed made of SiO₂, SiN or silica-based low dielectric constant insulating film, the etching is performed mainly based on a fluorocarbon-based gas.

The metal-containing film obtained by using the inventive composition for forming a metal-containing film is characterized by its excellent etching resistance at the time of etching of the body to be processed.

As an organic resist underlayer film material that can be used for the above-described resist underlayer film, examples include materials already known as materials for an underlayer film for a three-layer resist method or a two-layer resist method using a silicon resist composition. Examples include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

The resist underlayer film can be formed on the substrate to be processed, for example, by using a composition solution containing the above-described organic resist underlayer film material and by a spin-coating method or the like in the same manner as the photoresist composition. After forming the organic resist underlayer film by a spin-coating method or the like, it is desirable to bake the film in order to evaporate the organic solvent. The baking temperature is preferably 100 to 600°C, and the baking time is preferably 10 to 300 seconds.

Instead of the organic resist underlayer film material, it is also possible to adopt an organic hard mask formed by a CVD method or an ALD method.

In the case of the three-layer resist process, the dry etching of the metal-containing film is performed, for example, by using a chlorine-based gas while using the upper layer resist pattern as a mask. In this manner, the metal-containing film pattern is formed. Next, the resist underlayer film is etched by using an oxygen-based gas while using the obtained metal-containing film pattern as a mask. In this manner, the resist underlayer film pattern is formed. Next, the substrate to be processed is etched while using the obtained organic resist underlayer film pattern as a mask.

The metal-containing film obtained by using the inventive composition for forming a metal-containing film is characterized by its excellent etching resistance at the time of etching of the resist underlayer film.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films, such as those made of Si, SiO₂, SiON, SiN, p-Si, α-Si, W, W-Si, Al, Cu, Al-Si, and the like; and stopper films therefor, which can each be typically formed into a thickness of 50 to 10,000 nm, particularly 100 to 5,000 nm. When the layer to be processed is formed, the substrate and the layer to be processed are made of different materials.

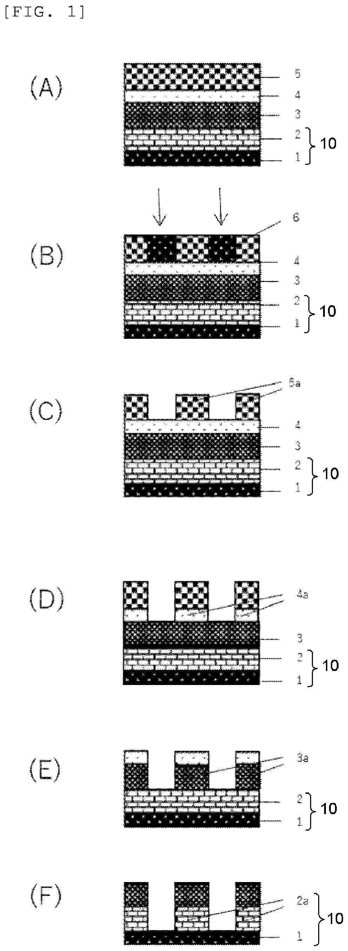

Here, with reference to FIG. 1, an example of a patterning process according to the above-described three-layer resist process will be described. In this example, firstly, a resist underlayer film 3 is formed on a layer 2 to be processed of a substrate 10 to be processed, including a substrate 1 and the layer 2 to be processed thereon, by using an organic resist underlayer film material, a metal-containing film 4 is formed on the resist underlayer film 3 by using the inventive composition for forming a metal-containing film, and a resist upper layer film 5 is formed on the metal-containing film 4 by using a photoresist material, as in FIG. 1(A). Subsequently, an exposure portion 6 of the resist upper layer film is subjected to pattern exposure as in FIG. 1(B). Then, development is performed with a developer to form a resist upper layer film pattern 5a in the resist upper layer film as in FIG. 1(C). Next, the pattern is transferred to the metal-containing film 4 by dry etching while using the resist upper layer film having the formed pattern 5a as a mask to obtain a metal-containing film pattern 4a as in FIG. 1(D). Subsequently, the pattern is transferred to the resist underlayer film by dry etching while using the metal-containing film having the transferred pattern 4a as a mask to obtain a resist underlayer film pattern 3a as in FIG. 1(E). Then, the layer 2 to be processed on the substrate 1 is processed while using the resist underlayer film having the formed pattern 3a as a mask to form a pattern 2a in the substrate 10 to be processed as in FIG. 1(F).

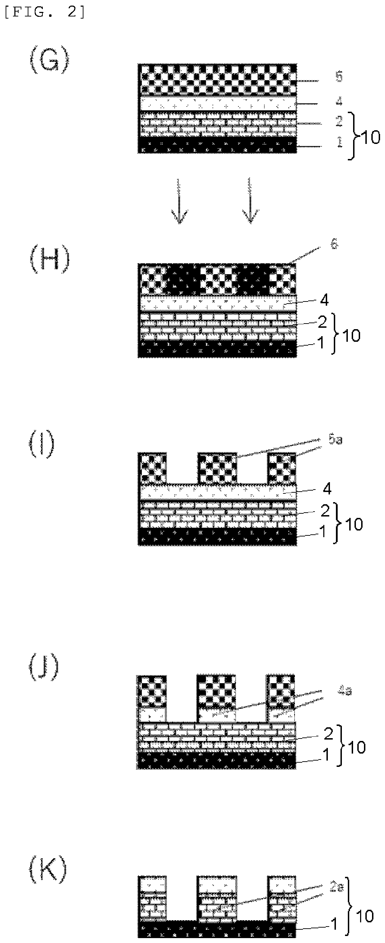

With reference to FIG. 2, an example of a patterning process according to the above-described two-layer resist process will be described. In this example, firstly, a metal-containing film 4 is formed on a layer 2 to be processed of a substrate 10 to be processed, including a substrate 1 and the layer 2 to be processed thereon, by using the inventive composition for forming a metal-containing film, and a resist upper layer film 5 is formed on the metal-containing film 4 by using a photoresist material, as in FIG. 2(G). Subsequently, an exposure portion 6 of the resist upper layer film is subjected to pattern exposure as in FIG. 2(H). Then, development is performed with a developer to form a resist upper layer film pattern 5a in the resist upper layer film as in FIG. 2(I). Next, the pattern is transferred to the metal-containing film 4 by dry etching while using the resist upper layer film having the formed pattern 5a as a mask to obtain a metal-containing film pattern 4a as in FIG. 2(J). Then, the layer 2 to be processed on the substrate 1 is processed while using the metal-containing film having the formed pattern 4a as a mask to form a pattern 2a in the substrate 10 to be processed as in FIG. 2(K).

### EXAMPLES

The present invention is further specifically described below with reference to Synthesis Examples, Comparative Synthesis Examples, Examples, and Comparative Examples. However, the present invention is not limited to these Examples.

### [Synthesis Example of Metal Compound (A)]

In the following Synthesis Examples, the following organic group starting material group G ((G1) to (G10)) and silicon-containing organic group starting material group H ((H1) and (H2)) were used.

The starting material group G ((G1) to (G10)) and the starting material group H ((H1) and (H2)) are shown below.

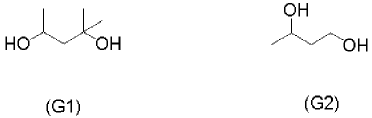

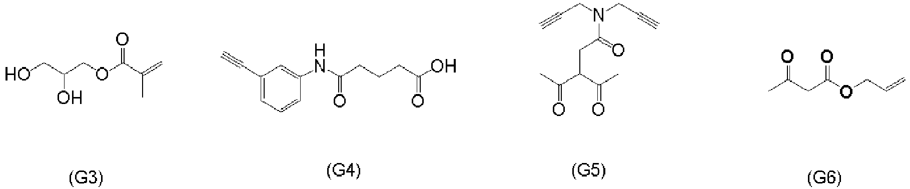

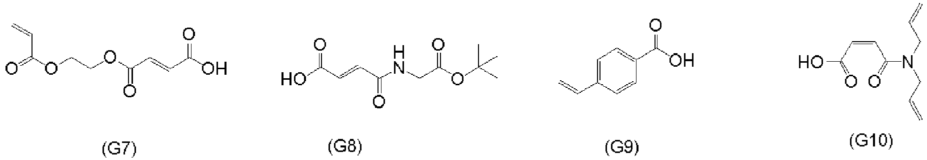

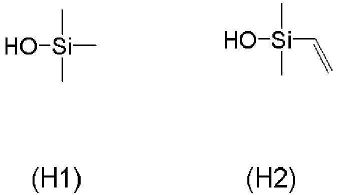

As a metal source M, the following metal compounds were used.
(M1): diisopropoxybis(2,4-pentanedionate)titanium(IV) (a solution in 2-propanol (IPA) with a concentration of 75 mass%)
(M2): titanium tetraisopropoxide (377996 available from Sigma-Aldrich Corp)
(M3): Zr(OBu)₄: zirconium(IV) tetrabutoxide (80 mass% solution in 1-butanol) (Z0016 available from Tokyo Chemical Industry Co., Ltd.)
(M4): Hf(OBu)₄: hafnium(IV) n-butoxide (667943 available from Sigma-Aldrich Corp)
(M5): Ti(OBu)₄: tetrabutyl orthotitanate (B0742 available from Tokyo Chemical Industry Co., Ltd.)
(M6): titanium butoxide tetramer (FUJIFILM Wako Pure Chemical Corporation)

### [Synthesis Example A1] Synthesis of Metal Compound (A-1)

Under a nitrogen atmosphere, 50.9 g of diisopropoxybis(2,4-pentanedionate)titanium(IV) (M1) (mass of metal compound: 38.2 g) was dissolved in 180.0 g of propylene glycol monoethyl ether (hereinafter, PGEE), and while stirring, 20.2 g of deionized water was added dropwise at room temperature over 10 minutes. Subsequently, a reaction was allowed to take place at 60°C for 2 hours, then the product was cooled to room temperature, 250 g of propylene glycol monoethyl ether was further added thereto, and then, concentration under reduced pressure was carried out using a rotary evaporator. Thus, a solution of a metal compound (A-1) in PGEE was obtained.

### [Synthesis Example A2] Synthesis of Metal Compound (A-2)

Under a nitrogen atmosphere, 28.4 g of titanium tetraisopropoxide (M2) was dissolved in 50.0 g of 2-propanol, and while stirring, 50.0 g of a solution of 2.7 g of deionized water in IPA was added dropwise at room temperature over 2 hours. To the obtained solution, 12.4 g of the organic group starting material group (G1) was added, and the mixture was agitated at room temperature for 30 minutes. After the solution was concentrated under reduced pressure at 30°C, it was further heated to 60°C and heating was continued under reduced pressure to generate no distillate. After observation no distillate, then, 120.0 g of a PGMEA/PGME (ratio by weight: 70/30) solution was added thereto and heated under reduced pressure at 40°C until no IPA was distilled. Thus, a solution of a metal compound (A-2) in PGMEA/PGME was obtained.

### [Synthesis Examples A3 to A8] Synthesis of Metal Compounds (A-3) to (A-8)

The metal compounds (A-3) to (A-8) shown in Table 1 were obtained under the same reaction conditions as in Synthesis Example A1, except that the metal source M and the compound group G were used at the charging amounts shown in Table 1.

**[Table 1]**

| Synthesis Example | Metal starting material | | Compound group G | | Metal compound |
|---|---|---|---|---|---|
| | Starting material | g | Starting material | g | |
| A1 | M1 | 50.9 | - | - | A-1 |
| A2 | M2 | 28.4 | G1 | 12.4 | A-2 |
| A3 | M3 | 47.9 | G2 | 9.0 | A-3 |
| A4 | M4 | 48.5 | G2 | 9.0 | A-4 |
| A5 | M2 | 33.4 | G3 | 18.8 | A-5 |
| A6 | M3 | 35.6 | G4 | 17.8 | A-6 |
| A7 | M4 | 56.9 | G5 | 26.7 | A-7 |
| A8 | M3 | 34.5 | G6 | 9.9 | A-8 |

### [Synthesis Example A9] Synthesis of Metal Compound (A-9)

Under a nitrogen atmosphere, 11.8 g of tetrabutyl orthotitanate (M5) was dissolved in 20.6 g of a PGMEA/PGME (ratio by weight: 70/30) solution. The reaction temperature was raised to 50°C while stirring, and 6.5 g of the compound H1 was added dropwise to the solution. After the addition, stirring was continued for 2 hours at a reaction temperature of 60°C. Subsequently, a mixture obtained by suspending 6.4 g of the compound G3 in 8.6 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a metal compound (A-9) in PGMEA/PGME was obtained.

### [Synthesis Examples A10 to A16] Synthesis of Metal Compounds (A-10) to (A-16)

The metal compounds (A-10) to (A-16) shown in Table 2 were obtained under the same reaction conditions as in Synthesis Example A9, except that the metal source M, the compound group G, and the compound group H were used at the charging amounts shown in Table 2.

**[Table 2]**

| Synthesis Example | Metal starting material | | Compound group G | | Compound group H | | Metal compound |
|---|---|---|---|---|---|---|---|
| | Starting material | g | Starting material | g | Starting material | g | |
| A9 | M5 | 11.8 | G3 | 6.4 | H1 | 6.5 | A-9 |
| A10 | M6 | 17.6 | G4 | 18.9 | H2 | 5.5 | A-10 |
| A11 | M3 | 20.9 | G5 | 5.6 | H1 | 7.8 | A-11 |
| A12 | M3 | 20.9 | G6 | 10.1 | H1 | 7.8 | A-12 |
| A13 | M3 | 20.9 | G7 | 9.8 | H1 | 7.8 | A-13 |
| A14 | M3 | 20.8 | G8 | 9.5 | H1 | 7.8 | A-14 |
| A15 | M3 | 20.8 | G9 | 6.5 | H1 | 7.8 | A-15 |
| A16 | M3 | 18.8 | G10 | 7.4 | H1 | 7.8 | A-16 |

### [Synthesis of Surface Modifier (B)]

Polymers (B-1) to (B-14) and comparative polymers (B-15) and (B-16) of the surface modifier (B) were synthesized. To prepare these polymers, the following monomers (J1) to (J13) were used.

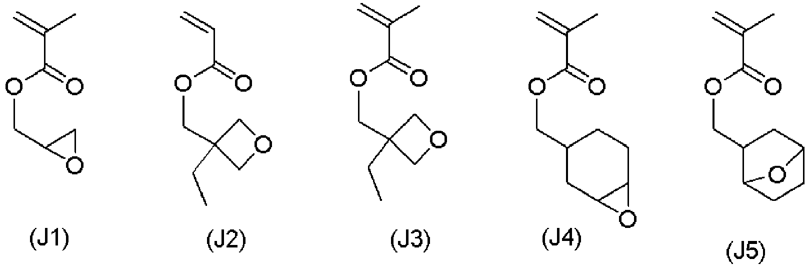

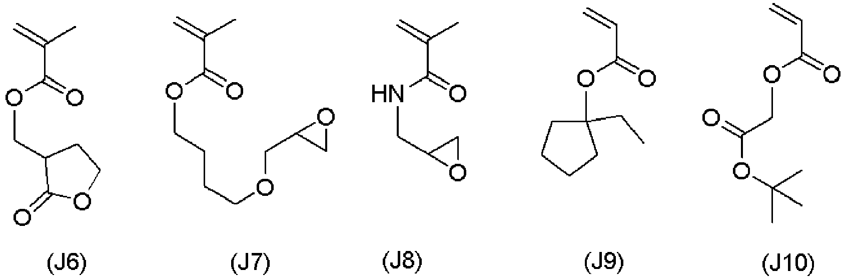

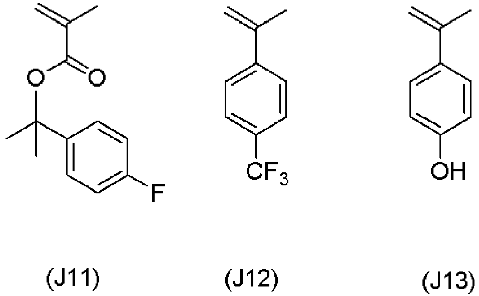

### [Synthesis Example B1] Synthesis of Polymer (B-1)

Into a 500-ml flask, 100 g of a monomer 1 (starting material J1) and 290.0 g of propylene glycol monomethyl ether acetate (hereinafter, written as "PGMEA") were measured and charged, and degassing was performed while stirring to prepare a monomer solution. Into a different 500-ml flask, 2.9 g of dimethyl-2,2-azobis(2-methylpropionate) (V-601 available from Wako Pure Chemical Corporation) as a polymerization initiator and 50.0 g of PGMEA were measured and charged, and degassing was performed while stirring to prepare a polymerization initiator solution. Furthermore, into a 1-L flask having a nitrogen atmosphere, 60 g of PGMEA was measured and charged, degassing was performed while stirring, and then the PGMEA was heated until the internal temperature was 80°C. The monomer solution and the polymerization initiator solution were added thereto simultaneously and separately over 4 hours. After the addition, the mixture was heated and stirred for 16 hours, and then cooled to room temperature. The obtained polymer solution was dropped into 1,500 g of stirred hexane, and the precipitated polymer was filtered. Furthermore, the obtained polymer was washed twice with 600 g of hexane, and then vacuum-dried at 50°C for 20 hours to obtain a polymer (B-1), which was a polymer in a white powder form. As a result of GPC analysis, it was found that the polymer (B-1) had a weight-average molecular weight (Mw) of 10,000 and a dispersity (Mw/Mn) of 2.0.

### [Synthesis Examples B2 to B14 and Comparative Synthesis Examples B15 and B16] Synthesis of Polymers (B-2) to (B-16)

The polymers (B-2) to (B-16) shown in Table 3 were obtained under the same reaction conditions as in Synthesis Example B1, except that the monomer 1, monomer 1 and monomer 2, or monomer 1, monomer 2, and monomer 3 were used at the charging amounts shown in Table 3. Table 3 below also shows the weight-average molecular weight (Mw) and dispersity (Mw/Mn) of each polymer.

**[Table 3]**

| Synthesis Example | Monomer 1 | | Monomer 2 | | Monomer 3 | | Polymerization initiator | Polymer | Mw | Mw/Mn |
|---|---|---|---|---|---|---|---|---|---|---|
| | Starting material | g | Starting material | g | Starting material | g | g | | | |
| B1 | J1 | 100 | - | | - | | 2.9 | B-1 | 10000 | 2.0 |
| B2 | J2 | 100 | - | | - | | 2.4 | B-2 | 13200 | 2.3 |
| B3 | J3 | 58 | J4 | 42 | - | | 1.5 | B-3 | 20000 | 2.4 |
| B4 | J4 | 92 | J9 | 8 | - | | 1.4 | B-4 | 21000 | 2.1 |
| B5 | J4 | 46 | J5 | 46 | J9 | 8 | 2.9 | B-5 | 8500 | 2.1 |
| B6 | J4 | 45 | J6 | 40 | J10 | 15 | 3.3 | B-6 | 6000 | 2.3 |
| B7 | J8 | 100 | - | | - | | 2.9 | B-7 | 12000 | 2.1 |
| B8 | J3 | 48 | J7 | 40 | J9 | 12 | 1.9 | B-8 | 16000 | 2.5 |
| B9 | J4 | 60 | J8 | 35 | J10 | 5 | 1.3 | B-9 | 22000 | 2.3 |
| B10 | J1 | 90 | J11 | 10 | - | | 1.2 | B-10 | 25000 | 2.5 |
| B11 | J1 | 40 | J2 | 30 | J11 | 30 | 1.2 | B-11 | 25000 | 2.4 |
| B12 | J3 | 60 | J4 | 30 | J12 | 10 | 1.3 | B-12 | 27000 | 2.3 |
| B13 | J3 | 65 | J8 | 30 | J11 | 5 | 1.6 | B-13 | 23000 | 2.3 |
| B14 | J3 | 80 | J11 | 20 | - | - | 1.9 | B-14 | 17000 | 2.2 |
| Comparative B15 | J10 | 100 | - | - | - | - | 2.0 | B-15 | 12000 | 2.0 |
| Comparative B16 | J4 | 50 | J6 | 35 | J13 | 15 | 2.3 | B-16 | 13000 | 2.5 |

### Preparation of Compositions (MUL-1 to -16 and Comparative MUL-1 to -5) for Forming Metal-Containing Film

For the preparation of compositions for forming a metal-containing film, the following were used: one of the metal compounds (A-1) to (A-16); one of the polymers (B-1) to (B-16) as a surface modifier; the following compounds (AG1) to (AG3) as a thermal acid generator; the following compound (AG4) or (AG5) as a photo-acid generator; the following compound (XL1) or (XL2) as a crosslinking agent; and a solvent (C1: ethylene glycol dibenzyl ether, having a boiling point of 364°C) as a high-boiling-point solvent. These were dissolved in an organic solvent containing 0.001 mass% of PF636 (available from OMNOVA Solutions Inc.) in proportions shown in Table 4, and then the solution was filtered through a 0.1-µm filter made of a fluororesin to prepare each of the compositions (MUL-1 to -16 and comparative MUL-1 to -5) for forming a metal-containing film. As the organic solvent, a mixed solvent of PGMEA and PGEE was used as shown in Table 4.

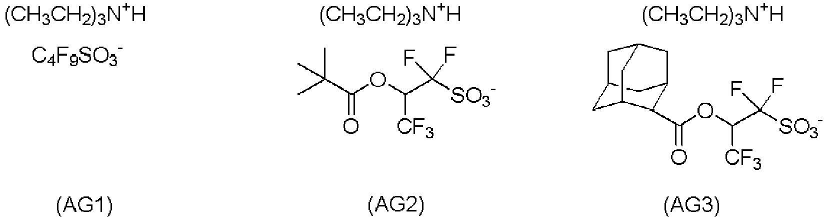

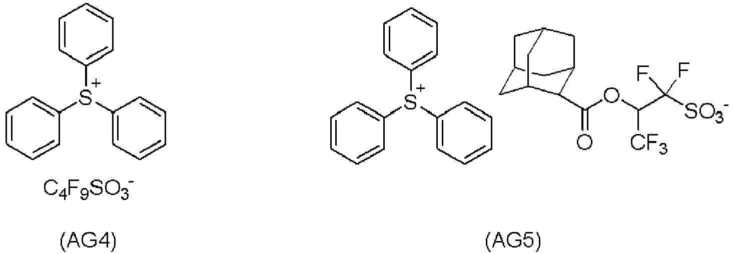

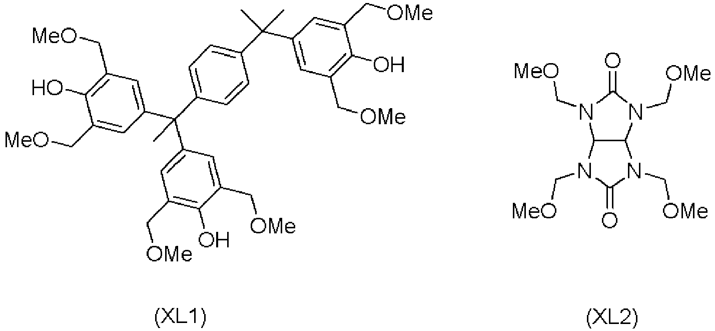

**[Table 4]**

| Composition for forming metal-containing film | (A) Metal compound | (B) Surface modifier | (D) Thermal acid generator | (E) Photo-acid generator | (F) Cross-linking agent | (C) Solvent | |
|---|---|---|---|---|---|---|---|
| | | | | | | (C1) High-boiling-point solvent | Organic solvent (containing surfactant (G)) |
| | (parts by mass) | (parts by mass) | (parts by mass) | (parts by mass) | (parts by mass) | (parts by mass) | (parts by mass) |
| MUL-1 | A-1(9) | B-1(1) | - | - | - | - | PGMEA/PGEE(160/80) |
| MUL-2 | A-2(9) | B-2(1) | AG1(0.2) | - | - | - | PGMEA/PGEE(160/80) |
| MUL-3 | A-3(9) | B-3(1) | AG1(0.2) | - | - | - | PGMEA/PGEE(160/80) |
| MUL-4 | A-4(9) | B-4(1) | AG1(0.2) | - | - | - | PGMEA/PGEE(160/80) |
| MUL-5 | A-5(9) | B-5(1) | AG1(0.2) | - | - | - | PGMEA/PGEE(160/80) |
| MUL-6 | A-6(9) | B-6(1) | AG1(0.2) | - | - | - | PGMEA/PGEE(160/80) |
| MUL-7 | A-7(9) | B-7(1) | - | - | - | - | PGMEA/PGEE(160/80) |
| MUL-8 | A-8(9) | B-8(1) | AG1(0.2) | - | - | - | PGMEA/PGEE(160/80) |
| MUL-9 | A-9(9) | B-9(1) | AG1(0.2) | - | - | - | PGMEA/PGEE(160/80) |
| MUL-10 | A-10(9) | B-10(1) | AG2(0.2) | - | - | - | PGMEA/PGEE(160/80) |
| MUL-11 | A-11(9) | B-11(1) | AG3(0.2) | | - | - | PGMEA/PGEE(160/80) |
| MUL-12 | A-12(9) | B-12(1) | AG1(0.2) | AG4(0.4) | - | - | PGMEA/PGEE(160/80) |
| MUL-13 | A-13(9) | 8-13(1) | AG2(0.2) | AG5(0.4) | - | - | PGMEA/PGEE(160/80) |
| MUL-14 | A-14(9) | B-14(1) | AG1(0.2) | - | XL1(0.5) | - | PGMEA/PGEE(160/80) |
| MUL-15 | A-15(9) | B-3(1) | AG1(0.2) | - | XL2(0.5) | - | PGMEA/PGEE(160/80) |
| MUL-16 | A-16(9) | B-4(1) | AG1(0.2) | - | - | C1(5) | PGMEA/PGEE(160/80) |
| Comparative MUL-1 | A-2(10) | - | - | - | - | - | PGMEA/PGEE(160/80) |
| Comparative MUL-2 | A-3(10) | - | - | - | - | - | PGMEA/PGEE(160/80) |
| Comparative MUL-3 | A-8(10) | - | - | - | - | - | PGMEA/PGEE(160/80) |
| Comparative MUL-4 | A-8(9) | B-15(1) | - | - | - | - | PGMEA/PGEE(160/80) |
| Comparative MUL-5 | A-8(9) | B-16(1) | - | - | - | - | PGMEA/PGEE(160/80) |

### [Solvent Resistance Evaluation and Contact Angle Evaluation]

In Examples 1-1 to 1-16 and Comparative Examples 1-1 to 1-4, each of the compositions (MUL-1 to -16 and comparative MUL-1 to -4) for forming a metal-containing film prepared above was respectively applied onto a silicon substrate, the coating film was baked at 250°C for 60 seconds, then the thickness of the coating film from the center of the substrate to the periphery was measured, and the average film thickness (a [nm]) was calculated. Subsequently, a PGMEA solvent was dispensed on the coating film, left to stand for 30 seconds, then spin-drying was performed, then the PGMEA was evaporated by baking at 100°C for 60 seconds, and the film thickness (b [nm]) of the coating film was measured. The difference between the film thicknesses of before and after the PGMEA treatment (film remaining percentage: (b/a) × 100) was calculated. The results are shown below in Table 5.

In addition, regarding the films baked at 250°C for 60 seconds, a contact angle (CA1) with pure water was measured. The results are shown below in Table 5.

In Comparative Example 1-5, where the composition (comparative MUL-5) for forming a metal-containing film was used, a precipitate was generated after preparing the sample, and therefore, the evaluation was stopped. It is conjectured that in the composition (comparative MUL-5) for forming a metal-containing film, the polymer (B-16), used as the surface modifier (B), contained a constitutional unit containing a hydroxy group, and therefore, the polymer reacted with the metal compound, and the precipitate was generated.

**[Table 5]**

| Example | Composition for forming metal-containing film | Baking temperature | Film thickness after film formation: a | Film thickness after solvent treatment: b | b/a × 100 | Contact angle (CA1) |
|---|---|---|---|---|---|---|
| | | | Å | Å | % | deg. |
| Example 1-1 | MUL-1 | 250°C | 503.5 | 503.1 | 100% | 61 |
| Example 1-2 | MUL-2 | 250°C | 501.7 | 501.8 | 100% | 60 |
| Example 1-3 | MUL-3 | 250°C | 503.7 | 503.6 | 100% | 60 |
| Example 1-4 | MUL-4 | 250°C | 507.0 | 507.0 | 100% | 60 |
| Example 1-5 | MUL-5 | 250°C | 500.3 | 500.3 | 100% | 65 |
| Example 1-6 | MUL-6 | 250°C | 507.3 | 507.2 | 100% | 66 |
| Example 1-7 | MUL-7 | 250°C | 505.5 | 505.6 | 100% | 65 |
| Example 1-8 | MUL-8 | 250°C | 500.8 | 500.8 | 100% | 66 |
| Example 1-9 | MUL-9 | 250°C | 503.1 | 503.0 | 100% | 63 |
| Example 1-10 | MUL-10 | 250°C | 502.3 | 502.2 | 100% | 65 |
| Example 1-11 | MUL-11 | 250°C | 504.1 | 504.1 | 100% | 64 |
| Example 1-12 | MUL-12 | 250°C | 506.3 | 506.3 | 100% | 65 |
| Example 1-13 | MUL-13 | 250°C | 500.8 | 500.7 | 100% | 64 |
| Example 1-14 | MUL-14 | 250°C | 500.4 | 500.5 | 100% | 65 |
| Example 1-15 | MUL-15 | 250°C | 501.4 | 501.3 | 100% | 62 |
| Example 1-16 | MUL-16 | 250°C | 501.8 | 501.8 | 100% | 64 |
| Comparative Example 1-1 | Comparative MUL-1 | 250°C | 443.3 | 443.3 | 100% | 37 |
| Comparative Example 1-2 | Comparative MUL-2 | 250°C | 447.9 | 447.8 | 100% | 38 |
| Comparative Example 1-3 | Comparative MUL-3 | 250°C | 424.5 | 424.4 | 100% | 40 |
| Comparative Example 1-4 | Comparative MUL-4 | 250°C | 479.1 | 479.0 | 100% | 54 |

As shown in Table 5, it can be observed that the metal-containing film materials (MUL-1 to -16) of the present invention all had excellent film-formability and underwent hardly any film loss due to the solvent treatment, and achieved films having excellent solvent resistance. In addition, by using the surface modifier, the films had a contact angle exceeding 60° to pure water, and it can be seen that excellent adhesiveness to a resist pattern can be expected. It was found that The contact angle was particularly high in Examples 1-5 to 1-16, where a metal compound containing a crosslinking group represented by any of the general formulae (a-1) to (a-4), (b-1) to (b-4), and (c-1) to (c-3) was used, and among these Examples, the contact angle was higher in Examples 1-5 to 1-8, where a hydrolysis condensation product of the metal compound (metal compounds A-5 to A-8) was contained, Examples 1-10 to 1-14, where a polymer containing a constitutional unit containing an F atom was contained as a surface modifier, and Example 1-16, where a high-boiling-point solvent was contained as an additive.

### [Etching Resistance Evaluation]

In Examples 2-1 to 2-16 and Comparative Examples 2-1 to 2-4, each of the compositions (MUL-1 to -16 and comparative MUL-1 to -4) for forming a metal-containing film was respectively applied onto a silicon substrate, and the coating film was heated by using a hot plate at 250°C for 60 seconds to form a metal-containing film having a film thickness of 50 nm (film thickness "a").

In Comparative Example 2-5, the following silicon-containing resist middle layer film composition (SOG-1) was applied, and the coating film was baked at 220°C for 60 seconds to form a resist middle layer film having a film thickness of 50 nm.

The silicon-containing resist middle layer film composition (SOG-1) was prepared by dissolving an ArF silicon-containing middle layer film polymer (SiP1) and a thermal crosslinking catalyst (CAT1) in a solvent containing 0.1 mass% of FC-4430 (available from Sumitomo 3M Limited) (a mixed solvent of the following solvent 1 and solvent 2) in the proportion shown in Table 6; and filtering the solution through a filter made of a fluororesin and having a pore size of 0.1 µm.

**[Table 6]**

| | Polymer | Thermal crosslinking catalyst | Solvent 1 | Solvent 2 |
|---|---|---|---|---|
| | (parts by mass) | (parts by mass) | (parts by mass) | (parts by mass) |
| SOG-1 | SiP1 | CAT1 | Propylene glycol monoethyl ether | Pure water |
| | (100) | (1) | (2900) | (400) |

The structural formulae of the used ArF silicon-containing middle layer film polymer (SiP1) and thermal crosslinking catalyst (CAT1) are shown below.

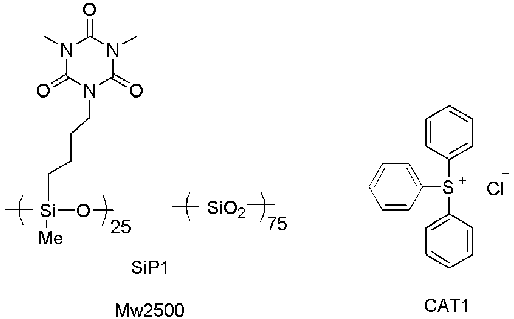

Subsequently, using an etching apparatus CE-300I manufactured by ULVAC, Inc., etching using a CF₄ gas and O₂ gas was each performed under the following conditions, and the film thickness "b" was measured. Then, the film thickness etched in one minute was calculated as an etching rate (nm/min) from the film thickness etched (film thickness "b" - film thickness "a") using the respective gas in a specified time. Table 7 shows the results.
Conditions of dry etching with CF₄ gas
   Pressure: 1 Pa
   Antenna RF power: 100 W
   Bias RF power: 15 W
   CF₄ gas flow rate: 15 sccm
   Time: 30 sec
Conditions of dry etching with O₂ gas
   Pressure: 1 Pa
   Antenna RF power: 300 W
   Bias RF power: 10 W
   O₂ gas flow rate: 25 sccm
   Time: 30 sec

**[Table 7]**

| Example | Composition for forming metal-containing film | Etching rate (nm/min) | Etching rate (nm/min) |
|---|---|---|---|
| | | CF₄ | O₂ |
| Example 2-1 | MUL-1 | 6.8 | 6.7 |
| Example 2-2 | MUL-2 | 6.5 | 6.7 |
| Example 2-3 | MUL-3 | 6.5 | 6.8 |
| Example 2-4 | MUL-4 | 6.5 | 6.8 |
| Example 2-5 | MUL-5 | 7.4 | 7.6 |
| Example 2-6 | MUL-6 | 8.8 | 10.4 |
| Example 2-7 | MUL-7 | 8.5 | 10.2 |
| Example 2-8 | MUL-8 | 7.8 | 8.0 |
| Example 2-9 | MUL-9 | 10.8 | 13.0 |
| Example 2-10 | MUL-10 | 12.3 | 14.8 |
| Example 2-11 | MUL-11 | 11.8 | 13.8 |
| Example 2-12 | MUL-12 | 11.3 | 13.0 |
| Example 2-13 | MUL-13 | 12.8 | 13.2 |
| Example 2-14 | MUL-14 | 12.6 | 13.1 |
| Example 2-15 | MUL-15 | 14.5 | 14.9 |
| Example 2-16 | MUL-16 | 12.8 | 13.3 |
| Comparative Example 2-1 | Comparative MUL-1 | 5.0 | 5.5 |
| Comparative Example 2-2 | Comparative MUL-2 | 5.1 | 5.3 |
| Comparative Example 2-3 | Comparative M U L-3 | 10.5 | 11.1 |
| Comparative Example 2-4 | Comparative MUL-4 | 11.4 | 11.6 |
| Comparative Example 2-5 | SOG-1 | 49.8 | 20.1 |

As shown in Table 7, it was shown that the inventive compositions (MUL-1 to -16) for forming a metal-containing film all exhibited excellent etching resistance to CF₄ gas and O₂ gas. Since the etching resistance to CF₄ gas is excellent, it can be said that the compositions are suitable for a two-layer resist process, where a resist pattern is transferred to a substrate to be processed by employing a combination with a photoresist upper layer film.

In addition, the metal-containing film compositions (MUL-1 to -16) of the present invention have better resistance to etching using O₂ gas than SOG-1, used in Comparative Example 2-5, and therefore, it can be said that the compositions are suitable for a three-layer resist process, where a resist pattern is transferred to a substrate to be processed by employing a combination with an organic resist underlayer film.

### [Patterning Process]

In Examples 3-1 to 3-3 and Comparative Examples 3-1 to 3-4, using ODL-306, available from Shin-Etsu Chemical Co., Ltd., an Si wafer was spin-coated, and the coating film was baked at 350°C for 60 seconds to fabricate a carbon film having a thickness of 45 nm as an organic underlayer film on the substrate. The carbon film had a carbon content of 88%. A composition obtained by diluting one of the compositions (MDL-3, -8, and -12 and comparative MDL-2 to -4) for forming a metal-containing film with an organic solvent (PGMEA/PGME = 700/300 parts by mass) was applied thereto, and heated by using a hot plate at 250°C for 60 seconds to form a resist middle layer film having a thickness of 10 nm. A monolayer resist for ArF as a resist upper layer film composition was applied thereto, and the coating film was baked at 105°C for 60 seconds to form a photoresist film having a thickness of 100 nm. A liquid immersion top coat composition (TC-1) was applied to the photoresist film, and the coating film was baked at 90°C for 60 seconds to form a top coat having a thickness of 50 nm.

In Comparative Example 3-4, a composition obtained by diluting the silicon-containing resist middle layer film material (SOG-1), used in Comparative Example 2-5, with an organic solvent (PGEE/pure water = 5000/600 parts by mass) was applied, and the coating film was baked at 220°C for 60 seconds to form a resist middle layer film having a thickness of 10 nm.

The resist upper layer film material (monolayer resist for ArF) was prepared by dissolving a polymer (RP1), an acid generator (PAG1), and a basic compound (Amine1), each in the proportion shown in Table 8, in a solvent containing 0.1% by mass of a surfactant FC-4430 (available from Sumitomo 3M Limited), and filtering the solution through a 0.1-pm filter made of a fluororesin.

**[Table 8]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2,500) |

The polymer (RP1), the acid generator (PAG1), and the basic compound (Amine1) used for the resist upper layer film material (monolayer resist for ArF) are shown below.

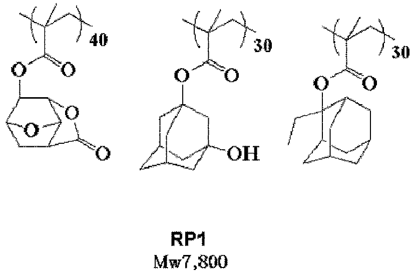

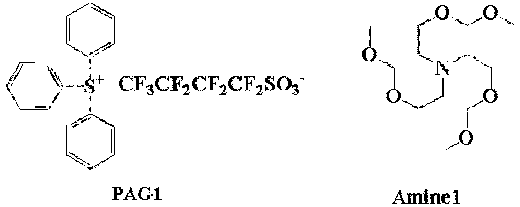

The liquid immersion top coat composition (TC-1) was prepared by dissolving a top coat polymer (PP1) in an organic solvent at the proportion shown in Table 9, and filtering the solution through a 0.1-pm filter made of a fluororesin.

**[Table 9]**

| | Top coat polymer (parts by mass) | Organic solvent (parts by mass) |
|---|---|---|
| TC-1 | PP1 (100) | Diisoamyl ether (2,700) |
| | | 2-methyl-1-butanol (270) |

The top coat polymer (PP1) used for the liquid immersion top coat composition (TC-1) is shown below.

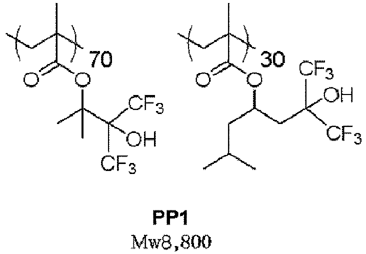

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 50 nm 1 : 1 positive line-and-space pattern (a resist upper layer film pattern).

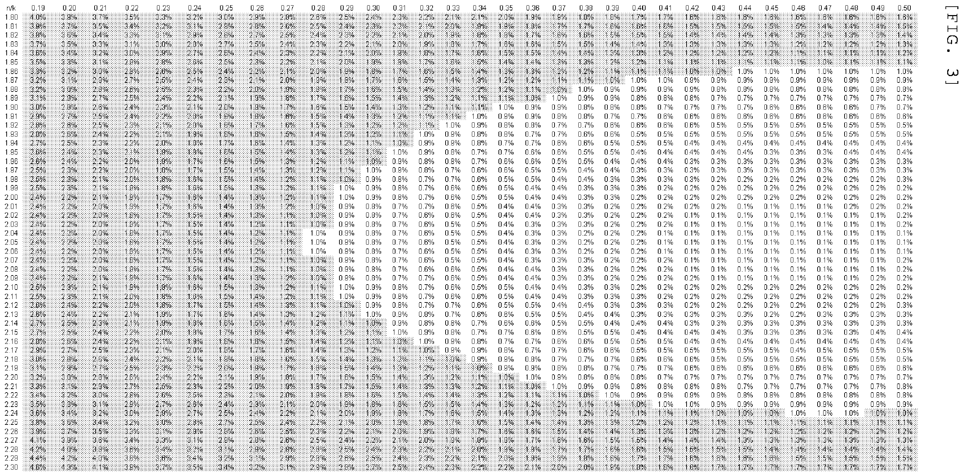

The calculation of reflectance was carried out using PROLITH 2020a (manufactured by Litho Tech Japan Corporation). With the film thickness of the metal-containing film fixed to 10 nm, the reflectance at which the refractive index "n" of the metal-containing film is 1.80 to 2.30 and the attenuation coefficient "k" is 0.19 to 0.50 at a wavelength of 193 nm was calculated, and the results are shown in FIG. 3. Optical constants (n/k) at which it is possible to reduce the reflectance from the underlying substrate during pattern exposure are preferable.

The optical constants of the compositions for forming a metal-containing film were determined by coating a silicon substrate with the composition for forming a metal-containing film, baking the coating film at 250°C for 60 seconds, and then determining the constants by using a spectroscopic ellipsometer (VASE) with variable angle of incidence manufactured by J. A. Woollam Japan.

The LWR of the pattern was observed with CG5000 (Hitachi High-Technologies Corp.), and pattern cross section was observed with S-4700 (electron microscope manufactured by Hitachi, Ltd.).

The results are shown in Table 10.

Subsequently, the resist middle layer film was etched by dry etching while using the resist upper layer film pattern as a mask to form a hard mask pattern, the organic underlayer film was etched while using the obtained hard mask pattern as a mask to form a pattern, and the SiO₂ film was etched while using the obtained resist underlayer film pattern as a mask. The etching conditions were as follows.

### (Examples 3-1 to 3-3 and Comparative Examples 3-1 to 3-3)

Conditions in transferring hard mask pattern to metal-containing film (resist middle layer film)
Conditions of dry etching with Cl₂ gas
   Pressure: 1 Pa
   Antenna RF power: 320 W
   Bias RF power: 30 W
   Cl₂ gas flow rate: 25 sccm
   Time: 10 sec

### (Comparative Example 3-4)

Conditions in transferring hard mask pattern to SOG-1 film (resist middle layer film)
Conditions of dry etching with CF₄ gas
   Pressure: 1 Pa
   Antenna RF power: 100 W
   Bias RF power: 15 W
   CF₄ gas flow rate: 15 sccm
   Time: 15 sec
Conditions in transferring resist middle layer film pattern to organic underlayer film
Conditions of dry etching with O₂ gas
   Pressure: 1 Pa
   Antenna RF power: 300 W
   Bias RF power: 10 W
   O₂ gas flow rate: 25 sccm
   Time: 20 sec
Conditions in transferring resist underlayer film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

**[Table 10]**

| Example | Composition for forming metal-containing film | n | k | Reflectance | After development | | After etching for transferring to substrate | |
|---|---|---|---|---|---|---|---|---|
| | | 193 nm | 193 nm | % | Pattern profile | LWR (nm) | Pattern profile | LWR (nm) |
| Example 3-1 | MUL-3 | 1.97 | 0.31 | 0.8 | Vertical profile | 2.2 | Vertical profile | 2.5 |
| Example 3-2 | MUL-8 | 1.96 | 0.32 | 0.8 | Vertical profile | 2.2 | Vertical profile | 2.4 |
| Example 3-3 | MUL-12 | 1.92 | 0.34 | 0.9 | Vertical profile | 2.2 | Vertical profile | 2.4 |
| Comparative Example 3-1 | Comparative MUL-2 | 2.10 | 0.40 | 0.2 | Pattern collapse | - | - | - |
| Comparative Example 3-2 | Comparative MUL-3 | 2.10 | 0.30 | 0.9 | Pattern collapse | - | - | - |
| Comparative Example 3-3 | Comparative MUL-4 | 1.96 | 0.33 | 0.8 | Pattern collapse | - | - | - |
| Comparative Example 3-4 | SOG-1 | 1.80 | 0.19 | 4.4 | Vertical profile | 3.9 | Undercut profile | 4.3 |

As shown in Table 10, in Examples 3-1 to 3-3, where the inventive compositions (MUL-3, -8, and -12) for forming a metal-containing film were used, it was observed that the pattern profile after development was excellent in every case. It is conjectured that the main factor for the successful achievement of excellent resist patterns is the fact that adhesiveness to the resist upper layer film pattern was enhanced by the surface modifier being contained, and the refractive index "n" at the wavelength 193 nm was high, so that the light reflected from the substrate was suppressed to 1% or less even in the case of a thin film with a thickness of 10 nm. The inventive composition for forming a metal-containing film can improve adhesiveness to a resist pattern without degrading characteristics as a high refractive index material, and is particularly effective when a composition for forming a metal-containing film that contains zirconium, which exhibits a high refractive index at a wavelength of 193 nm, is used as a resist underlayer film.

In addition, after the etching after transference to the substrate, the resist upper layer film pattern was successfully transferred to the substrate in the end, and it was confirmed that the composition can be used suitably in fine processing according to a multilayer resist method.

In Comparative Examples 3-1 and 3-2, where no surface modifier was used, and Comparative Example 3-3, where a polymer different from that of the present invention was used as a surface modifier, collapse of the resist upper layer film pattern was observed after development.

In Comparative Example 3-4, where SOG-1 was used as a resist middle layer film composition, it was observed that the LWR after the development was poor compared to Examples 3-1 to 3-3, where the inventive compositions (MUL-3, -8, and -12) for forming a metal-containing film were used, possibly because the reflectance at the time of the pattern exposure had a high value of 4.4%. In addition, in Comparative Example 3-4, it was observed that the pattern profile after etching for transferring to the substrate was an undercut profile. This is conjectured to be because the resistance to the oxygen gas used when processing the resist underlayer film by dry etching was insufficient.

From the above, it was revealed that the inventive composition for forming a metal-containing film and inventive patterning processes provide high adhesiveness to a resist upper layer film pattern, have an effect of suppressing the collapse of a fine pattern, and give a high-rectangularity pattern profile of a resist upper layer film, and therefore, are particularly suitably used in multilayer resist processes and are extremely useful in fine patterning for manufacturing semiconductor devices.

The present description includes the following embodiments.
[1] A composition for forming a metal-containing film, comprising:
   (A) a metal compound;
   (B) a surface modifier; and
   (C) a solvent,

   wherein the metal compound contains at least one kind of metal atom selected from the group consisting of Ti, Zr, and Hf, and
   the surface modifier (B) is a polymer containing one or both of a repeating unit represented by the following general formula (1) and a repeating unit represented by the following general formula (2), and the polymer does not contain a repeating unit containing a hydroxy group, 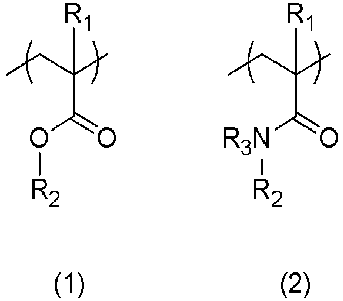 wherein R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.
[2] The composition for forming a metal-containing film according to [1], wherein the heterocyclic structure contains an oxygen atom.
[3] The composition for forming a metal-containing film according to [1] or [2], wherein the R₂ in the general formulae (1) and (2) represents a monovalent organic group containing a group selected from the following formulae (R₂-1) to (R₂-3), 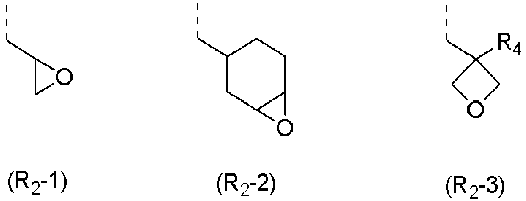 wherein R₄ represents a hydrogen atom or an alkyl group having 1 to 10 carbon atoms; and a broken line represents an attachment point.
[4] The composition for forming a metal-containing film according to any one of [1] to [3], wherein the surface modifier (B) is a polymer further containing any repeating unit represented by the following formula (3a) or formula (3b), 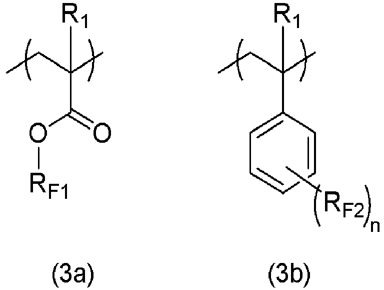 wherein R_{F1} represents a monovalent organic group having 1 to 20 carbon atoms and containing at least one F atom; R_{F2} represents an F atom or a monovalent organic group having 1 to 10 carbon atoms and containing one or more F atoms; R₁ represents a hydrogen atom or a methyl group; and "n" represents 1 to 5.
[5] The composition for forming a metal-containing film according to any one of [1] to [4], wherein the polymer, which is the surface modifier (B), has a weight-average molecular weight of 6,000 to 50,000.
[6] The composition for forming a metal-containing film according to any one of [1] to [5], wherein the polymer, which is the surface modifier (B), has a dispersity of 3.0 or less, the dispersity being expressed as "weight-average molecular weight"/"number-average molecular weight".
[7] The composition for forming a metal-containing film according to any one of [1] to [6], wherein the surface modifier (B) contained in the composition for forming a metal-containing film is contained in a ratio of 1 part by mass or more and 50 parts by mass or less to 100 parts by mass of the metal compound.
[8] The composition for forming a metal-containing film according to any one of [1] to [7], further comprising at least one of:
   (D) a thermal acid generator;
   (E) a photo-acid generator;
   (F) a crosslinking agent; and
   (G) a surfactant.
[9] The composition for forming a metal-containing film according to any one of [1] to [8], wherein the solvent (C) contains a high-boiling-point solvent (C-1), and
   the high-boiling-point solvent (C-1) is one or more kinds of organic solvent having a boiling point of 180°C or higher.
[10] The composition for forming a metal-containing film according to any one of [1] to [9], wherein the metal compound (A) is derived from a metal compound represented by the following general formula (4),

   LₐMX_{b} (4)

   wherein M represents any of Ti, Zr, and Hf; L represents a monodentate ligand having 1 to 30 carbon atoms or a polydentate ligand having 1 to 30 carbon atoms; X represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.
[11] The composition for forming a metal-containing film according to [10], wherein the metal compound (A) is a reaction product of a reaction between: a compound derived from the metal compound represented by the general formula (4); and an organic compound having 1 to 30 carbon atoms and containing at least one crosslinking group represented by any of the following general formulae (a-1) to (a-4), (b-1) to (b-4), and (c-1) to (c-3), 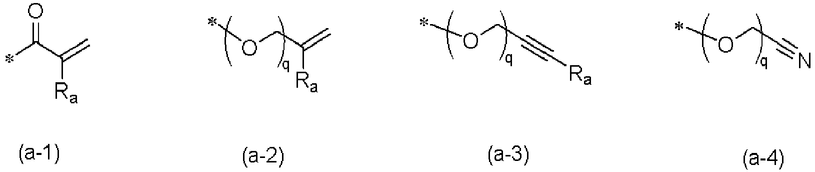 wherein Rₐ represents a hydrogen atom or a monovalent organic group having 1 to 10 carbon atoms, "q" represents 0 or 1, and "*" represents an attachment point, 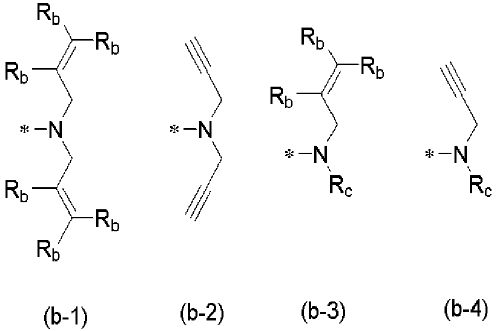 wherein R_{b}s each represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 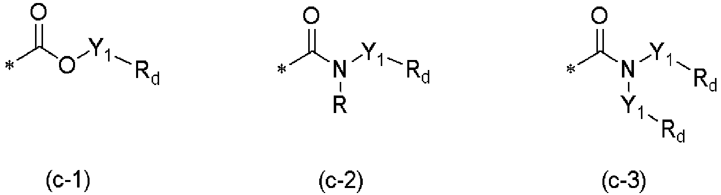 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R_{d} represents an organic group whose protecting group is to be removed by an action of an acid, heat, or both to generate one or more hydroxy groups or carboxy groups, R_{d} being represented by one of the following general formulae (c-4), and "*" represents an attachment point, 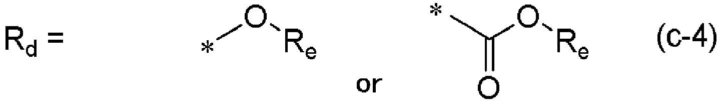 wherein Rₑ represents an organic group whose protecting group is to be removed by an action of an acid, heat, or both, and "*" represents an attachment point to Y₁.
[12] A patterning process for forming a pattern in a substrate to be processed, comprising the steps of:
   (I-1) applying the composition for forming a metal-containing film according to any one of [1] to [11] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[13] A patterning process for forming a pattern in a substrate to be processed, comprising the steps of:
   (II-1) forming a resist underlayer film on a substrate to be processed;
   (II-2) applying the composition for forming a metal-containing film according to any one of [1] to [11] onto the resist underlayer film, followed by heating to form a metal-containing film;
   (II-3) forming a resist upper layer film on the metal-containing film by using a photoresist material;
   (II-4) subjecting the resist upper layer film to pattern exposure and then development with a developer to form a pattern in the resist upper layer film;
   (II-5) transferring the pattern to the metal-containing film by dry etching while using the resist upper layer film having the formed pattern as a mask;
   (II-6) transferring the pattern to the resist underlayer film by dry etching while using the metal-containing film having the transferred pattern as a mask; and
   (II-7) processing the substrate to be processed while using the resist underlayer film having the formed pattern as a mask to form the pattern in the substrate to be processed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a metal-containing film, comprising:
(A) a metal compound;
(B) a surface modifier; and
(C) a solvent,
wherein the metal compound contains at least one kind of metal atom selected from the group consisting of Ti, Zr, and Hf, and
the surface modifier (B) is a polymer containing one or both of a repeating unit represented by the following general formula (1) and a repeating unit represented by the following general formula (2), and the polymer does not contain a repeating unit containing a hydroxy group, 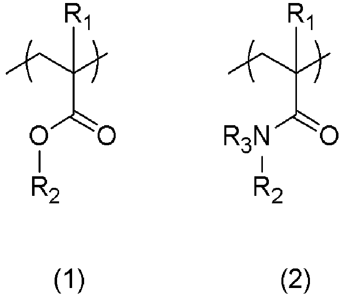
wherein R₁ represents a hydrogen atom or a methyl group, R₂ represents a monovalent organic group having 2 to 20 carbon atoms and containing a heterocyclic structure, and R₃ represents a hydrogen atom or a linear or branched alkyl group having 1 to 3 carbon atoms.

2. The composition for forming a metal-containing film according to claim 1, wherein the heterocyclic structure contains an oxygen atom.

3. The composition for forming a metal-containing film according to claim 1 or 2, wherein the R₂ in the general formulae (1) and (2) represents a monovalent organic group containing a group selected from the following formulae (R₂-1) to (R₂-3), 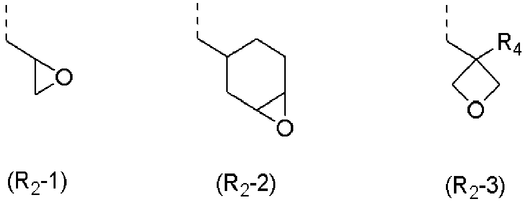 wherein R₄ represents a hydrogen atom or an alkyl group having 1 to 10 carbon atoms; and a broken line represents an attachment point.

4. The composition for forming a metal-containing film according to any one of claims 1 to 3, wherein the surface modifier (B) is a polymer further containing any repeating unit represented by the following formula (3a) or formula (3b), 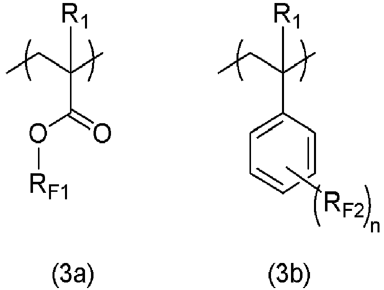 wherein R_{F1} represents a monovalent organic group having 1 to 20 carbon atoms and containing at least one F atom; R_{F2} represents an F atom or a monovalent organic group having 1 to 10 carbon atoms and containing one or more F atoms; R₁ represents a hydrogen atom or a methyl group; and "n" represents 1 to 5.

5. The composition for forming a metal-containing film according to any one of claims 1 to 4, wherein the polymer, which is the surface modifier (B), has a weight-average molecular weight of 6,000 to 50,000.

6. The composition for forming a metal-containing film according to any one of claims 1 to 5, wherein the polymer, which is the surface modifier (B), has a dispersity of 3.0 or less, the dispersity being expressed as "weight-average molecular weight"/"number-average molecular weight".

7. The composition for forming a metal-containing film according to any one of claims 1 to 6, wherein the surface modifier (B) contained in the composition for forming a metal-containing film is contained in a ratio of 1 part by mass or more and 50 parts by mass or less to 100 parts by mass of the metal compound.

8. The composition for forming a metal-containing film according to any one of claims 1 to 7, further comprising at least one of:
(D) a thermal acid generator;
(E) a photo-acid generator;
(F) a crosslinking agent; and
(G) a surfactant.

9. The composition for forming a metal-containing film according to any one of claims 1 to 8, wherein the solvent (C) contains a high-boiling-point solvent (C-1), and
the high-boiling-point solvent (C-1) is one or more kinds of organic solvent having a boiling point of 180°C or higher.

10. The composition for forming a metal-containing film according to any one of claims 1 to 9, wherein the metal compound (A) is derived from a metal compound represented by the following general formula (4),
LₐMX_{b} (4)
wherein M represents any of Ti, Zr, and Hf; L represents a monodentate ligand having 1 to 30 carbon atoms or a polydentate ligand having 1 to 30 carbon atoms; X represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

11. The composition for forming a metal-containing film according to claim 10, wherein the metal compound (A) is a reaction product of a reaction between: a compound derived from the metal compound represented by the general formula (4); and an organic compound having 1 to 30 carbon atoms and containing at least one crosslinking group represented by any of the following general formulae (a-1) to (a-4), (b-1) to (b-4), and (c-1) to (c-3), 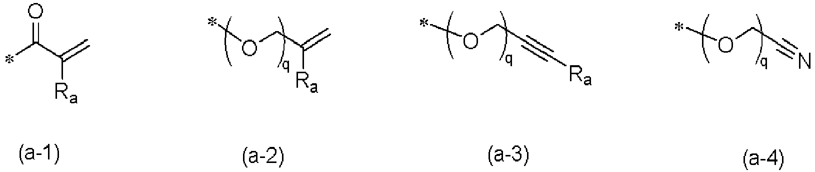 wherein R^{a} represents a hydrogen atom or a monovalent organic group having 1 to 10 carbon atoms, "q" represents 0 or 1, and "*" represents an attachment point, 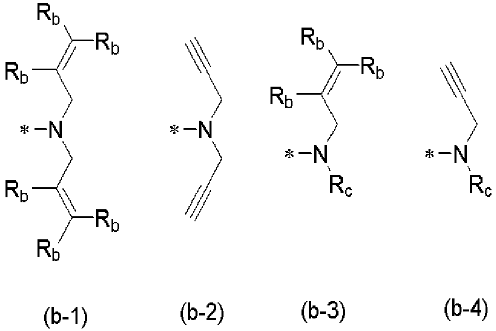 wherein R_{b}s each represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 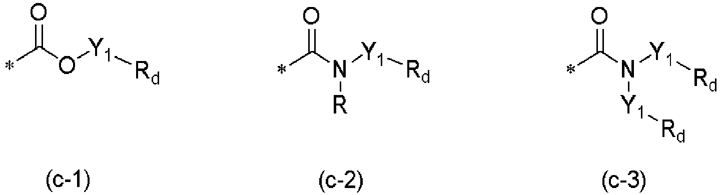 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R_{d} represents an organic group whose protecting group is to be removed by an action of an acid, heat, or both to generate one or more hydroxy groups or carboxy groups, R_{d} being represented by one of the following general formulae (c-4), and "*" represents an attachment point, 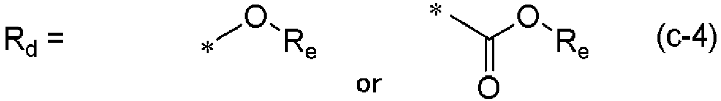 wherein Rₑ represents an organic group whose protecting group is to be removed by an action of an acid, heat, or both, and "*" represents an attachment point to Y₁.

12. A patterning process for forming a pattern in a substrate to be processed, comprising the steps of:
(I-1) applying the composition for forming a metal-containing film according to any one of claims 1 to 11 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

13. A patterning process for forming a pattern in a substrate to be processed, comprising the steps of:
(II-1) forming a resist underlayer film on a substrate to be processed;
(II-2) applying the composition for forming a metal-containing film according to any one of claims 1 to 11 onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.
